# EUROPÄISCHE PATENTSCHRIFT

(11) **EP 2 531 772 B1**
(45) Veröffentlichungstag und Bekanntmachung des Hinweises auf die Patenterteilung: **30.09.2015**
(21) Anmeldenummer: 11745955.2
(22) Anmeldetag: 09.08.2011
(51) Int. Cl.: F21V 19/00, F21V 29/00, F21V 99/00

(54) **LEITERPLATTE MIT MINDESTENS EINER HALBLEITERLICHTQUELLE, AUFLAGE FÜR DIE LEITERPLATTE, SYSTEM AUS DER LEITERPLATTE UND DER AUFLAGE SOWIE VERFAHREN ZUM BEFESTIGEN DER LEITERPLATTE AN DER AUFLAGE**
PRINTED CIRCUIT BOARD HAVING AT LEAST ONE SEMICONDUCTOR LIGHT SOURCE, SUPPORT FOR THE PRINTED CIRCUIT BOARD, SYSTEM COMPRISING THE PRINTED CIRCUIT BOARD AND THE SUPPORT, AND METHOD FOR MOUNTING THE PRINTED CIRCUIT BOARD ON THE SUPPORT
PLAQUETTE DE CIRCUITS IMPRIMÉS COMPORTANT AU MOINS UNE SOURCE DE LUMIÈRE À SEMI-CONDUCTEURS, SUPPORT POUR LA PLAQUETTE, SYSTÈME COMPOSÉ DE LA PLAQUETTE ET DU SUPPORT ET PROCÉDÉ POUR FIXER LA PLAQUETTE SUR LE SUPPORT

(30) Priorität: 10.08.2010 CN 201010257403; 10.08.2010 DE 102010039120
(43) Veröffentlichungstag der Anmeldung: 12.12.2012
(73) Patentinhaber: OSRAM GmbH, 80807 München (DE)
(72) Erfinder: SACHSENWEGER, Peter, 93197 Zeitlarn (DE); CHEN, Yuli, Guangdong 518053 (CN); LIANG, Zhenjian, Guangdong 518053 (CN); WANG, Xuefeng, Guangdong 518053 (CN); ZENG, Junhua, Guangdong 518053 (CN)
(86) Internationale Anmeldenummer: PCT/EP2011/063680
(87) Internationale Veröffentlichungsnummer: WO 2012/020013

(56) Entgegenhaltungen:
- WO-A1-2008/123670
- WO-A1-2010/061746
- JP-A- 2003 068 129
- US-A1- 2008 093 998

## Beschreibung

Die Erfindung betrifft eine Leiterplatte, die dazu eingerichtet ist, mit mindestens einer Halbleiterlichtquelle ausgerüstet zu sein. Die Erfindung betrifft ferner eine Auflage für die Leiterplatte. Die Erfindung betrifft auch ein System aus der Leiterplatte und der Auflage. Die Erfindung betrifft zudem ein Verfahren zum Befestigen der Leiterplatte an der Auflage.

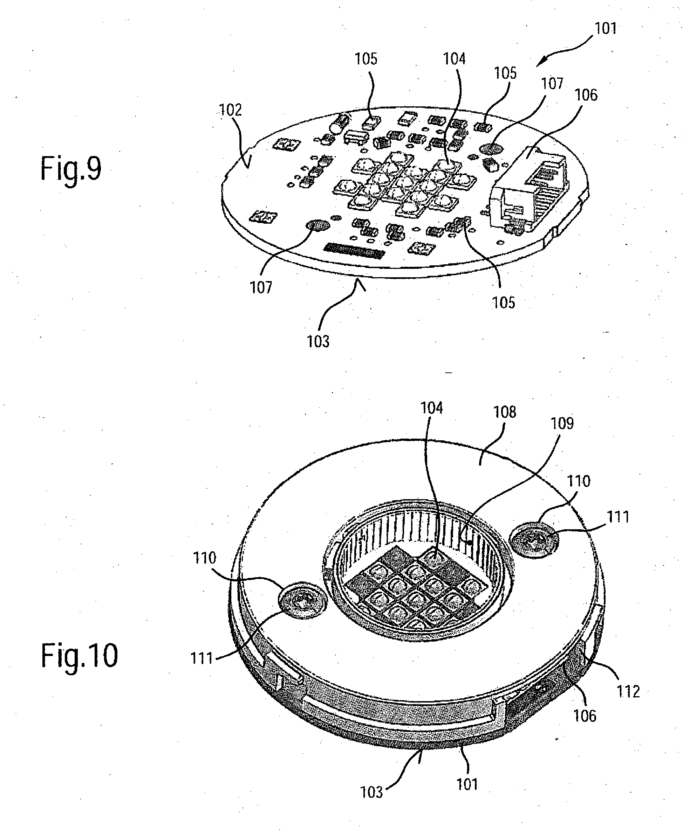

**Fig.9** zeigt in einer Ansicht von schräg oben eine Leiterplatte 101, welche an ihrer Vorderseite 102 bestückt und an ihrer Rückseite 103 nicht bestückt ist. Die Vorderseite ist in einem zentralen Bereich mit mehreren Leuchtdioden 104 und um die Leuchtdioden 104 herum mit mehreren, auch unterschiedlichen elektronischen Bauelementen 105 bestückt. Die elektronischen Bauelemente 105 können z.B. mittels eines Reflow-Lötens auf die Vorderseite 102 aufgebracht worden sein. Außerdem ist an einem Randbereich der Vorderseite 102, und nach außen ausgerichtet, ein Steckverbindungselement 106 befestigt. Mittels des Steckverbindungselements 106 sind die elektrisch betreibbaren Elemente an der Vorderseite 102 (Leuchtdioden 104 und elektronische Bauelemente 105) mit einem Strom bzw. einer Spannung versorgbar. Die Vorderseite ist dazu mit einer (nicht gezeigten) Leiterbahn- oder Leitungsstruktur versehen, welche die elektrisch betreibbaren Elemente 104, 105 miteinander und mit dem Steckverbindungselement 106 elektrisch verbindet.

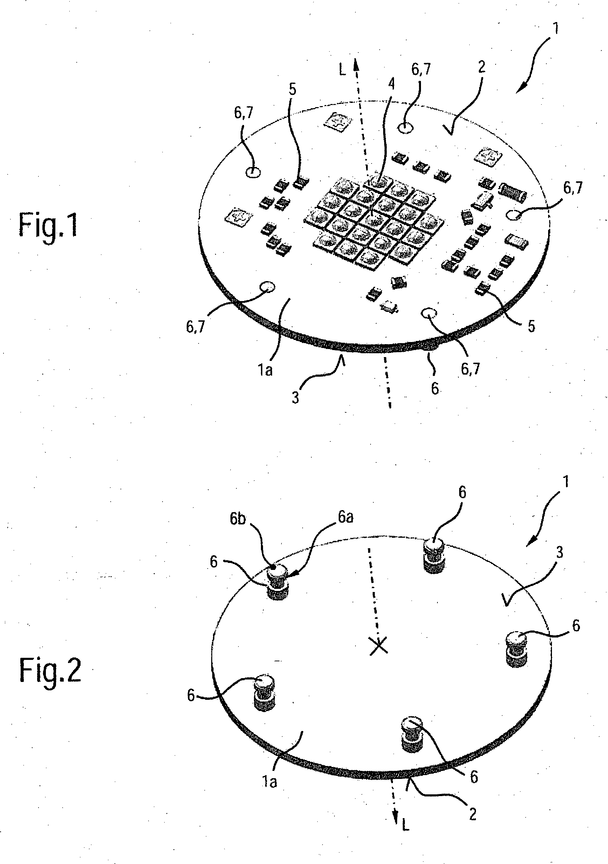

Die Leiterplatte 101 wird zu ihrer Befestigung mit ihrer Rückseite 103 auf eine Auflage, z.B. einen Kühlkörper, aufgesetzt und verschraubt. Davor wird ihr eine Ringabdeckung 108 aufgesetzt, wie in Bezug auf Fig.2 genauer erläutert wird. Für die Verschraubung weist die Leiterplatte 101 hier zwei Schraubendurchführungen 107 auf.

**Fig. 10** zeigt in einer Ansicht von schräg oben die Leiterplatte 101 mit einer die elektronischen Bauelemente 105 abdeckenden ringförmigen Ringabdeckung 108. Die Leiterplatte 101 und die Ringabdeckung 108 können auch als ein LED-Modul bezeichnet werden. Eine Innenwand 109 der Ringabdeckung 108 dient als eine Reflektorwand für die Leuchtdioden 104. Die Ringabdeckung 108 weist ebenfalls zwei Schraublöcher 110 auf, so dass zwei Schrauben 111 jeweils durch die Schraublöcher 110, 107 hindurchgeführt und mit der Auflage verschraubt werden können. Die angezogenen Schrauben pressen die Ringabdeckung 108 dichtend auf die Vorderseite 102 der Leiterplatte 101 und die Leiterplatte 101 mit ihrer Rückseite 103 auf die Auflage.

Für eine elektrische Kontaktierung weist die Ringabdeckung zudem eine seitliche Einführöffnung 112 auf, durch welche das Steckverbindungselement 106 zugänglich ist und durch welche z.B. ein passendes Steckverbindungs-Gegenelement einführbar ist.

Die gezeigte Leiterplatte 101 weist den Nachteil auf, dass für die seitliche elektrische Kontaktierung ein entsprechendes Volumen neben der Leiterplatte 101 bzw. der Ringabdeckung 108 zur Unterbringung des externen Steckverbindungs-Gegenelements und für eine Kabelführung bereitgestellt werden muss. Zudem vergrößert das Steckverbindungselement 106 eine Bauhöhe erheblich. Auch wird auf der Leiterplatte 101 durch das Vorsehen der Schraublöcher 107 eine Flächenbelegung verschlechtert. Darüber hinaus bewirken die Schrauben 111 eine in Draufsicht nachteilige Anmutung.

Es sind Glühlampen-Retrofitlampen bekannt, welche einen Kühlkörper aufweisen, in den eine Treiberkavität integriert ist. An einer vorderseitigen Auflagefläche des Kühlkörpers ist eine Leiterplatte angebracht, welche mit mindestens einer Leuchtdiode bestückt ist. Die Treiberkavität wird rückwärtig durch einen Sockel abgeschlossen, über den ein in der Treiberkavität befindlicher Treiber an eine Netzspannung anschließbar ist. Die Ausgänge des Treibers sind elektrisch mit der mindestens einen Leuchtdiode zum Versorgen der Leuchtdiode mit einem geeigneten Strom- oder Spannungssignal verbunden. Dazu ist in dem Kühlkörper eine Aussparung in Form einer Durchführung zwischen der Treiberkavität und der Auflagefläche vorhanden, durch welche passende Kabel geführt werden können. Zur Befestigung der Leiterplatte an dem Kühlkörper wird die Leiterplatte seitlich in den Kühlkörper eingeklemmt, mit dem Kühlkörper verschraubt oder an den Kühlkörper angeklebt.

Bei einer solchen Glühlampen-Retrofitlampe ist es nachteilig, dass die Verdrahtung nur vergleichsweise aufwändig durchführbar ist, z.B. wegen eines Einführens und Verlötens der Kabel. Auch ist die Befestigung der Leiterplatte an dem Kühlkörper vergleichsweise aufwändig, z.B. durch eine notwendige Bereitstellung von Schrauben und Werkzeug im Falle einer Schraubverbindung sowie durch eine vergleichsweise kleine Größe der Schrauben (z.B. M3 oder M4).

Es ist die **Aufgabe** der vorliegenden Erfindung, bekannte Nachteile von Halbleiterleuchtvorrichtungen, insbesondere von Halbleiterleuchtvorrichtungen wie oben beschrieben, zumindest teilweise zu beseitigen und insbesondere eine besonders einfach zu montierende Halbleiterleuchtvorrichtung, insbesondere Halbleiterlampe, bereitzustellen.
Es ist weiterhin die **Aufgabe** der vorliegenden Erfindung, Nachteile von mit Halbleiterlichtquellen bestückten Leiterplatten und/oder Nachteile der beschriebenen Leiterplatte zumindest teilweise zu beseitigen und insbesondere eine Leiterplatte mit einer geringen Bauhöhe bereitzustellen, welche sich besonders platzsparend befestigen lässt.

Diese Aufgabe wird gemäß den Merkmalen der unabhängigen Ansprüche gelöst. Bevorzugte Ausführungsformen sind insbesondere den abhängigen Ansprüchen entnehmbar.

Die Aufgabe wird gelöst durch eine Leiterplatte, gemäß Anspruch 1.

Die Rückseite kann insbesondere mindestens ein Befestigungselement aufweisen. Die Leiterplatte kann folglich eine Vorderseite zum Bestücken mit mindestens einer Halbleiterlichtquelle und eine Rückseite mit mindestens einem Befestigungselement aufweisen, wobei das mindestens eine Befestigungselement als ein elektrisches Durchleitungselement für mindestens eine der Halbleiterlichtquellen ausgebildet ist.

Die Vorderseite der Leiterplatte kann zum Bestücken mit der mindestens einen Halbleiterlichtquelle eine entsprechende Leiterbahnstruktur aufweisen. Die Leiterbahnstruktur kann Kontaktflächen zum Befestigen der mindestens einen Halbleiterlichtquelle aufweisen. Die Leiterbahnstruktur kann ferner dazu eingerichtet sein, mit mindestens einem elektronischen Bauelement (Widerständen, Kondensatoren und/oder integrierten Schaltkreisen usw., z.B. in einer Oberflächenmontagetechnik (SMT))bestückt zu sein und kann auch dazu entsprechende Kontaktflächen aufweisen.

Es ist zudem eine Ausgestaltung, dass mindestens ein elektrisch leitfähiges Befestigungselement durch die Leiterplatte durchgeführt ist. So kann eine von der Vorderseite der Leiterplatte aus zugängliche Fläche, z.B. Vorderseite oder Oberseite, des mindestens einen Befestigungselements als eine Kontaktfläche verwendet werden, z.B. zum Anschluss an eine Leiterbahn, als eine Kontaktfläche für eine Drahtverbindung ('Wirebondpad') oder als eine SMD-Oberfläche.

Das mindestens eine Befestigungselement, das auch als das elektrische Durchleitungselement dient, mag folglich insbesondere mit mindestens einer Kontaktfläche der Vorderseite der Leiterplatte elektrisch verbunden sein oder eine solche Kontaktfläche darstellen.

Das als das elektrische Durchleitungselement dienende Befestigungselement kann insbesondere ein elektrisches Leitungselement sein, also selbst zumindest bereichsweise elektrisch leitend sein und folglich einen Teil des elektrischen Pfads zur der Halbleiterlichtquelle darstellen. Das Befestigungselement kann insbesondere mit einer Leiterbahnstruktur elektrisch verbunden sein.

Alternativ braucht das als das elektrische Durchleitungselement dienende Befestigungselement selbst kein elektrisches Leitungselement zu sein, und also selbst nicht elektrisch leitend sein, jedoch eine Durchleitung einer elektrischen Leitung, welche durch ein passendes Befestigungsgegenelement bereitgestellt wird, zulassen.

Es ist auch eine nicht beanspruchte Ausgestaltung, dass die Leiterplatte mehrere Befestigungselemente aufweist, welche insbesondere symmetrisch zu einer Symmetrieachse der Leiterplatte angeordnet sind, insbesondere drehsymmetrisch, rotationssymmetrisch oder winkelsymmetrisch. Die Leiterplatte kann insbesondere zwei Befestigungselemente aufweisen.

Die Befestigungselemente können insbesondere punktkreisförmig angeordnet sein, und zwar z.B. einreihig oder mehrreihig, aber beispielsweise auch radial angeordnet sein.

Es ist insbesondere eine Weiterbildung, dass die Leiterplatte mit mehreren, insbesondere zwei, Befestigungselementen in Form von durchgehenden Aussparungen, insbesondere Schlüssellöchern, versehen ist. Die Schlüssellöcher können insbesondere auf der Vorderseite der Leiterplatte jeweils mit einem Lötbereich versehen sein, welcher sich insbesondere an dem Bartbereich, insbesondere an einem von einem Augenbereich entfernten Ende des Schlüssellochs, befindet. Der Lötbereich kann elektrisch mit der Leiterbahnstruktur verbunden sein.

Gemäß der Erfindung weist die Leiterplatte mehrere Befestigungselemente auf, welche kodiert ausgestaltet und/oder angeordnet sind. Dadurch kann sichergestellt werden, dass die Befestigungselemente korrekt angeschlossen sind.

Es ist eine Weiterbildung, dass die Befestigungselemente für eine Kodierung eine gleiche Form aufweisen, aber an der Rückseite der Leiterplatte kodiert angeordnet sind. Eine kodierte Anordnung gemäß der Erfindung ist eine nicht-winkelsymmetrische Anordnung oder Verteilung. Eine mögliche nichtwinkelsymmetrische Anordnung kann beispielsweise eine punktkreisförmige oder sektorweise punktkreisförmige Anordnung sein, wobei mindestens ein zusätzliches Befestigungselement außerhalb der punktkreisförmigen Anordnung vorhanden ist, z.B. nach innen (in Richtung der Symmetrieachse oder Längsachse) versetzt.

Es ist eine noch Weiterbildung, dass mindestens ein Befestigungselement aus einer Gruppe von mehreren Befestigungselementen eine zu den anderen Befestigungselementen der Gruppe unterschiedliche Form aufweist. Beispielsweise kann dieses mindestens eine Befestigungselement eine Form aufweisen, welche nicht in eine zugehörige Aussparung für die anderen Befestigungselemente der Gruppe passt, z.B. dadurch, dass es wesentlich breiter oder länger ausgebildet ist.

Diese beiden Arten der Kodierung können auch kombiniert werden.

Es ist noch eine Ausgestaltung, dass das mindestens eine Befestigungselement jeweils einen Befestigungsbereich aufweist, an welchem ein passendes Befestigungsgegenelement kraftschlüssig, formschlüssig und/oder stoffschlüssig befestigbar ist. Es ist beispielsweise eine Ausgestaltung, dass das Befestigungselement an seinem Befestigungsbereich eine Klammer aufweist. Das Befestigungselement kann an seinem Befestigungsbereich jedoch jedes geeignete Rastelement aufweisen.

Es ist eine spezielle Ausgestaltung zum Befestigen eines eingreifenden Befestigungsgegenelements, dass der Befestigungsbereich als ein vorderseitig angeordneter Lötbereich ausgestaltet ist, welcher Lötmaterial aufweist. Der Lötbereich kann dazu vorgesehen sein, dass ein dort vorhandenes Befestigungsgegenelement mit der Leiterplatte bzw. mit dem Befestigungselement verlötet wird, z.B. durch ein Reflow-Löten. Der Lötbereich kann insbesondere (vor einer Befestigung der Leiterplatte an der Auflage) mit einem Lötmaterial vorbelegt sein, was ein Verlöten erleichtert.

In einer besonders bevorzugten Alternative kann das Lötmaterial des Lötbereichs als ein duktiles und gut elektrisch leitendes Kontaktmaterial für eine sichere elektrische Kontaktierung des Befestigungsgegenelements vorgesehen sein, und zwar ohne ein Verlöten.

Das Lötmaterial kann insbesondere eine Zinn/Blei-Mischung sein, insbesondere eine Zinn/Blei-Schicht gemäß dem ASTM International-Standard B579-73(2004) "Standard Specification for Electrodeposited Coatings of Tin-Lead Alloy" (sog. "Solder Plate").

Der Befestigungsbereich kann dazu eingerichtet sein, das Befestigungsgegenelement lösbar oder unlösbar zu befestigen oder zu halten.

Der Befestigungsbereich kann insbesondere elektrisch mit einer Leiterbahnstruktur verbunden sein.

Die Vorderseite der Leiterplatte kann insbesondere mit der mindestens einen Halbleiterlichtquelle und/oder mit dem mindestens einen elektronischen Bauelement bestückt sein.

Die Leiterplatte kann ein Basismaterial (Substrat) aus Keramik, aufweisen. Die Leiterplatte kann ferner ein herkömmliches Basismaterial aufweisen, wie FR4. Die Leiterplatte mag zudem als eine Metallkernplatine (MCPCB) o.ä. ausgebildet sein, um eine verbesserte Wärmespreizung zu erreichen.

Diese Leiterplatte ergibt den Vorteil, dass die mechanische Verbindung oder Befestigung und die elektrische Verbindung miteinander integriert werden und so Verbindungselemente eingespart werden können. Zudem wird durch den rückseitigerigen mechanischen und elektrischen Anschluss eine besonders kompakte Bauform erreicht, beispielsweise durch einen Entfall einer seitlichen elektrischen Kontaktierung und einer Reduzierung einer Baugruppenhöhe, da der bisher verwendete elektrische Stecker häufig das höchste an der herkömmlichen Leiterplatte angebrachte Bauteil ist. Zudem kann auf separate Befestigungselemente wie Schrauben usw. verzichtet werden, was einen Montageaufwand reduziert. Durch die rückwärtige Befestigung kann zudem an der Vorderseite eine bessere Flächennutzung ermöglicht werden, als auch eine verbesserte Anmutung aufgrund der nicht mehr notwendigen Anordnung der separaten Befestigungselemente an der Vorderseite. Außerdem lässt sich eine Zahl der Zuleitungen auf eine einfache Weise durch die Zahl der als elektrische Durchleitungselemente dienenden Befestigungselemente einstellen. Auch eine große Zahl an Befestigungselementen lässt sich ohne eine Vergrößerung der Bauform an der Rückseite der Leiterplatte anordnen.

Die Rückseite der Leiterplatte kann insbesondere als eine Auflagefläche dienen. Aufgrund ihrer vergleichsweise großen Fläche wird so eine gute Wärmeableitung von der mindestens einen Halbleiterlichtquelle durch die Rückseite ermöglicht.

Bevorzugterweise umfasst die mindestens eine Halbleiterlichtquelle mindestens eine Leuchtdiode. Bei Vorliegen mehrerer Leuchtdioden können diese in der gleichen Farbe oder in verschiedenen Farben leuchten. Eine Farbe kann monochrom (z.B. rot, grün, blau usw.) oder multichrom (z.B. weiß) sein. Auch kann das von der mindestens einen Leuchtdiode abgestrahlte Licht ein infrarotes Licht (IR-LED) oder ein ultraviolettes Licht (UV-LED) sein. Mehrere Leuchtdioden können ein Mischlicht erzeugen; z.B. ein weißes Mischlicht. Die mindestens eine Leuchtdiode kann mindestens einen wellenlängenumwandelnden Leuchtstoff enthalten (Konversions-LED). Die mindestens eine Leuchtdiode kann in Form mindestens einer einzeln gehäusten Leuchtdiode oder in Form mindestens eines LED-Chips vorliegen. Mehrere LED-Chips können auf einem gemeinsamen Substrat ("Submount") montiert sein. Die mindestens eine Leuchtdiode kann mit mindestens einer eigenen und/oder gemeinsamen Optik zur Strahlführung ausgerüstet sein, z.B. mindestens einer Fresnel-Linse, Kollimator, und so weiter. Anstelle oder zusätzlich zu anorganischen Leuchtdioden, z.B. auf Basis von InGaN oder AlInGaP, sind allgemein auch organische LEDs (OLEDs, z.B. Polymer-OLEDs) einsetzbar. Alternativ kann die mindestens eine Halbleiterlichtquelle z.B. mindestens einen Diodenlaser aufweisen.

Es ist eine Ausgestaltung, dass die Leiterplatte eine Rückseite mit mindestens einem Befestigungselement aufweist. Die Leiterplatte weist dann insbesondere eine Vorderseite zum Bestücken mit mindestens einer Halbleiterlichtquelle und eine Rückseite mit mindestens einem Befestigungselement auf, wobei das mindestens eine Befestigungselement als ein elektrisches Durchleitungselement, insbesondere Leitungselement ausgebildet ist.

Es ist eine weitere Ausgestaltung, dass das mindestens eine Befestigungselement mindestens ein von der Rückseite vorspringendes, elektrisch leitfähiges Befestigungselement umfasst.

Es ist noch eine Ausgestaltung, dass das mindestens eine Befestigungselement mindestens einen von der Rückseite vorspringenden, elektrisch leitfähigen Befestigungsstift umfasst. Ein solcher Befestigungsstift lässt sich besonders einfach in eine passende Aussparung der Auflage einsetzen. Zudem lässt sich ein Befestigungsstift auch besonders einfach an der Leiterplatte befestigen, z.B. durch ein Reflow-Löten, für eine besonders einfache Befestigung auch in einem Reflow-Prozess mit anderen durch den Reflow-Prozess an der Leiterplatte zu befestigenden Elementen.

Der mindestens eine Befestigungsstift mag insbesondere senkrecht von der Rückseite der Leiterplatte vorstehen oder abgehen. Der mindestens eine Befestigungsstift mag eine zylinderförmige, insbesondere kreiszylinderförmige, Grundform aufweisen. In noch einer Weiterbildung weist der mindestens eine Befestigungsstift ein seitlich verbreitertes freies Ende oder einen (insbesondere umlaufenden) Rücksprung auf, so dass er besonders einfach insbesondere formschlüssig in einer Aufnahme gehalten werden kann. Der mindestens eine Befestigungsstift mag insbesondere gleichförmig oder formähnlich zu einem GU-Stift (einem Stift eines Steckers einer GU-Verbindung, wie z.B. für Halogenlampen bekannt) ausgebildet sein.

Jedoch ist die Leiterplatte nicht auf eine Ausgestaltung des mindestens einen Befestigungselements in Form eines Befestigungsstifts beschränkt. So mag das mindestens eine Befestigungselement beispielsweise auch als ein Haken, insbesondere Rasthaken, eine Nase, insbesondere Rastnase, usw. vorliegen.

Alternativ oder zusätzlich kann das mindestens eine Befestigungselement als mindestens eine Aufnahme oder Aussparung zur Aufnahme eines vorspringenden Befestigungsgegenelements der Auflage ausgebildet sein. Die mindestens eine Aufnahme kann insbesondere als ein jeweiliger Durchbruch durch die Leiterplatte, also in Form einer durch die Leiterplatte durchgeführten Aussparung ausgestaltet sein. Dadurch können von der Rückseite aus passende vorspringende Befestigungsgegenelemente, z.B. Befestigungsstifte, durch das mindestens eine Befestigungselement geführt werden, wodurch das mindestens eine Befestigungsgegenelement von der Vorderseite der Leiterplatte aus zugänglich ist und einfach mit der mindestens einen Halbleiterlichtquelle bzw. deren elektrischen Kontaktfelder(n) elektrisch kontaktierbar ist. So kann eine von der Vorderseite der Leiterplatte aus zugängliche Fläche des mindestens einen Befestigungsgegenelements als eine Kontaktfläche verwendet werden, z.B. zum Anschluss an eine Leiterbahn, als auch als eine Kontaktfläche für eine Drahtverbindung ('Wirebondpad') oder als eine SMD-Oberfläche.

Es ist noch eine Ausgestaltung, dass das mindestens eine Befestigungselement in Form eines Schlüssellochs vorliegt. Das Schlüsselloch ermöglicht eine sichere, zumindest formschlüssige, vorzugsweise form- und kraftschlüssige, Befestigung mittels einer besonders einfachen Steck-/Dreh-Bewegung. Auch ist das Schlüsselloch besonders einfach einzubringen. Der Befestigungsbereich des Schlüssellochs kann insbesondere an einem Bartbereich vorhanden sein oder dem Bartbereich entsprechen.

Jedoch kann das mindestens eine Befestigungselement auch eine andersförmige Aussparung aufweisen, z.B. in Form eines Einstecklochs.

Alternativ oder zusätzlich kann das mindestens eine Befestigungselement mindestens ein von der Rückseite vorspringendes, elektrisch leitfähiges Befestigungselement umfassen.

Die Aufgabe wird auch gelöst durch eine Auflage, insbesondere für eine Leiterplatte wie oben beschrieben, wobei die Auflage mindestens eine Auflagefläche zum zumindest mittelbaren (direkten oder indirekten) Auflegen der Leiterplatte aufweist, wobei an der Auflagefläche mindestens ein Befestigungsgegenelement zum Befestigen eines Befestigungselements der Leiterplatte angeordnet ist und wobei mindestens ein Befestigunggegenelement als ein elektrisches Durchleitungselement ausgebildet ist.

Die Auflage ermöglicht die gleichen Vorteile wie bereits für die Leiterplatte beschrieben. Die Auflage kann zudem besonders einfach ausgebildet werden.

Die Aufgabe wird auch gelöst durch eine Auflage, insbesondere für eine Leiterplatte wie oben beschrieben, wobei die-Leiterplatte mindestens eine Auflagefläche zum zumindest mittelbaren (direkten oder indirekten) Auflegen der Leiterplatte aufweist, wobei an der Auflagefläche mindestens ein Befestigungsgegenelement zum Befestigen eines Befestigungselements der Leiterplatte angeordnet ist und wobei mindestens ein Befestigungsgegenelement ein elektrisch leitendes Befestigungsgegenelement ist, das mit mindestens einer elektrischen Versorgung (z.B. einem Netzanschluss, ggf. über einen Treiber) funktional / elektrisch verbunden ist. Die Auflage kann somit die Leiterplatte mittels des gleichen Befestigungsgegenelements mechanisch halten und elektrisch kontaktieren. Die Auflage ermöglicht die gleichen Vorteile wie bereits für die Leiterplatte beschrieben. Die Auflage kann zudem besonders einfach ausgebildet werden.

Es ist eine Ausgestaltung, dass mindestens ein Befestigungsgegenelement als ein elektrisches Leitungselement ausgestaltet ist und dazu selbst zumindest abschnittsweise elektrisch leitend ist. Das Befestigungsgegenelement stellt folglich einen Teil des elektrischen Pfads zu der Leiterplatte bzw. der mindestens einen Halbleiterlichtquelle dar. Die Auflage kann so die Leiterplatte mechanisch halten und elektrisch kontaktieren.

Es ist eine Ausgestaltung, dass Befestigungsgegenelement dann insbesondere mit mindestens einer elektrischen Versorgung verbunden ist.

Alternativ kann das Befestigungsgegenelement als ein selbst nicht elektrisch leitendes Durchleitungselement ausgestaltet sein, jedoch eine Durchleitung einer elektrischen Leitung, welche durch ein passendes Befestigungselement bereitgestellt wird, zulassen. Beispielsweise kann das Befestigungsgegenelement eine Aussparung in einer grundsätzlich elektrisch isolierenden Leiterplatte, z.B. aus FR4, sein, durch welche ein passender, elektrisch leitender Stift durchgeführt wird, wobei eine elektrische Verdrahtung nur an dem Stift, nicht an der Aussparung, erfolgt.

Es ist eine Ausgestaltung, dass das mindestens eine Befestigungsgegenelement jeweils in Form einer Aussparung zur Aufnahme eines vorspringenden Befestigungselements der Leiterplatte vorliegt. Die Aussparung ist folglich so ausgebildet, dass sie bei einem Eingriff durch das zugehörige Befestigungselement der Leiterplatte dieses mechanisch (kraft-, stoff-und/oder formschlüssig) hält und insbesondere elektrisch kontaktiert.

Alternativ oder zusätzlich kann, falls das mindestens eine Befestigungselement der Leiterplatte eine Aussparung umfassen kann, das mindestens eine Befestigungsgegenelement auch als ein Vorsprung, z.B. Befestigungsstift, vorliegen.

Es ist noch eine Ausgestaltung, dass das mindestens eine Befestigungsgegenelement in Form eines Schlüssellochs vorliegt. So kann das Befestigungselement, insbesondere falls es eine stiftartige Ausgestaltung aufweist, durch eine einfach Steck/Dreh-Bewegung sicher zumindest formschlüssig, vorzugweise form- und kraftschlüssig, an der Auflage gehalten werden.

Jedoch kann das mindestens eine Befestigungsgegenelement auch eine andere Form aufweisen, z.B. in Form eines Einstecklochs.

Es ist ferner eine Ausgestaltung, dass das mindestens eine Befestigungsgegenelement mindestens ein, insbesondere federndes, Rastmittel zum, insbesondere lösbaren, Verrasten eines eingesetzten Befestigungselements aufweist. Das mindestens eine Befestigungsgegenelement kann allgemein zum lösbaren oder nicht-lösbaren Verrasten ausgestaltet sein. Für den Fall, dass das mindestens eine Befestigungsgegenelement in Form eines Schlüssellochs vorliegt, kann z.B. unterhalb des Bartbereichs des Schlüssellochs eine offene Klammer angeordnet sein, in welche ein Befestigungsstift einrastbar ist.

Es ist eine Weiterbildung, dass das Rastmittel mindestens eines Befestigungsgegenelements mit der elektrischen Versorgung verbunden ist.

Die Auflage kann insbesondere als Kühlkörper oder als Teil eines Kühlkörpers ausgebildet sein. Der Kühlkörper kann ein dedizierter Kühlkörper sein. Der Kühlkörper kann aber z.B. auch ein Teil einer Leuchte sein. Die Auflage kann aber auch jedes andere geeignete Objekt sein, z.B. ein Treibergehäuse.

Es ist eine Ausgestaltung, dass das mindestens eine Befestigungsgegenelement als ein Vorsprung ausgestaltet ist. Es ist eine spezielle Ausgestaltung, dass das mindestens eine Befestigungsgegenelement mindestens einen von der Auflagefläche vorspringenden, elektrisch leitfähigen Befestigungsstift umfasst. Das mindestens eine Befestigungsgegenelement umfasst bevorzugt zwei elektrisch leitfähige Befestigungsstifte.
Die Auflage kann insbesondere ein Gehäuse, insbesondere Treibergehäuse, sein. Das Treibergehäuse kann auch mit einem Sockel verbunden sein, insbesondere dadurch abgeschlossen sein. Das Treibergehäuse kann insbesondere das mindestens eine Befestigungsgegenelement und den Sockel an gegenüberliegenden Enden aufweisen, z.B. an gegenüberliegenden Deckflächen, falls das Gehäuse zylindrisch, insbesondere kreiszylindrisch, ausgestaltet ist.

Ein in dem Treibergehäuse untergebrachter Treiber kann eine Treiberplatine aufweisen, an welcher die Befestigungsgegenelemente, insbesondere Befestigungsstifte, angebracht sind. Die Befestigungsgegenelemente können dann beispielsweise durch eine Wand des Treibergehäuses geführt sein.

Die Aufgabe wird auch gelöst durch ein System aus der Leiterplatte wie oben beschrieben und der Auflage wie oben beschrieben, wobei die Leiterplatte an der Auflage zumindest mittelbar befestigt ist, indem das mindestens eine Befestigungselement der Leiterplatte formschlüssig, kraftschlüssig und/oder stoffschlüssig in ein jeweils passendes Befestigungsgegenelement der Auflage eingreift, oder umgekehrt. Dies ermöglicht die bereits oben beschriebenen Vorteile.

Bei dem System ist die Versorgung (beispielsweise eine Stromoder Spannungsversorgung, z.B. ein Treiber) über das Befestigungsgegenelement und ggf. das zugehörige Befestigungselement zumindest mit einer Kontaktfläche der Vorderseite der Leiterplatte elektrisch verbunden, falls die Vorderseite bereits bestückt ist, auch elektrisch mit der mindestens einen Halbleiterquelle verbunden.

Insbesondere kann die Rückseite der Leiterplatte flächig auf der Auflagefläche der Auflage aufliegen, was eine effektive Wärmeabfuhr von der Vorderseite der Leiterplatte erlaubt

Es ist eine zur Wärmeabfuhr von der Vorderseite der Leiterplatte besonders vorteilhafte Ausgestaltung, dass zwischen der Leiterplatte und der Auflage eine thermisch leitfähige Lage eingebracht ist. Die thermisch leitfähige Lage kann z.B. ein thermisches Schnittstellenmaterial (TIM; "Thermal Interface Material") aufweisen, z.B. einen Wärmeleitkleber, eine Wärmeleitpaste, eine Wärmeleitfolie, ein Wärmeleitkissen usw. Falls die thermisch leitfähige Lage ein festes Material umfasst, z.B. die Wärmeleitfolie oder das Wärmeleitkissen, kann die thermisch leitfähige Lage an der Position des mindestens eines Befestigungselements oder Befestigungsgegenelements eine Aussparung aufweisen, um eine Verbindung dieser beiden Elemente nicht zu behindern. Die thermisch leitfähige Lage kann somit mindestens eine Aussparung zur Durchführung des Befestigungselements und/oder des Befestigungsgegenelements aufweisen.

Die thermisch gut leitfähige Lage ist vorzugsweise in einer Dickenrichtung elastisch nachgiebig, so dass diese Lage auch als ein Federelement dienen kann, welches einen Höhenausgleich oder Längenausgleich als auch eine kraftschlüssige Befestigung der Leiterplatte an der Auflage ermöglicht.

Es ist noch eine Ausgestaltung, dass zwischen der Leiterplatte und der Auflage (insbesondere im Falle eines Gehäuses, insbesondere Treibergehäuses) ein Kühlkörper eingebracht ist, wobei der Kühlkörper mindestens eine Aussparung zur Durchführung des Befestigungselements und/oder des Befestigungsgegenelements aufweist. So kann der Kühlkörper mittels einer einfachen Steckbewegung an dem System befestigt werden.

Es ist eine Weiterbildung, dass der Kühlkörper zumindest teilweise über die Auflage gesteckt ist. Dadurch kann der Kühlkörper sicher fixiert werden und zudem eine effektive Kühlung der Auflage, insbesondere des Treibergehäuses, erreichen.

Es ist noch eine Weiterbildung, dass die Leiterplatte an einer Aufnahme des Kühlkörpers angeordnet ist. Dadurch werden eine wirksame seitliche Lagefixierung der Leiterplatte sowie eine gute Wärmeüberleitung zwischen der Leiterplatte und dem Kühlkörper ermöglicht. Insbesondere kann die Leiterplatte mit ihrer Rückseite flächig auf dem Kühlkörper, insbesondere in dessen Aufnahme, auflegen, um eine große Wärmeübertragungsfläche zu erreichen.

Es ist ferner eine Weiterbildung, dass das System mindestens ein Fixierelement zum Fixieren einer Position, insbesondere Drehlage, der Leiterplatte aufweist. Das Fixierelement kann insbesondere eine Drehung relativ zu dem Kühlköper und/oder der Auflage verhindern, um so insbesondere ein unbeabsichtigtes Lösen / Zurückdrehen der Leiterplatten nach einer zuvor erfolgten Drehbewegung der Leiterplatte zu deren Befestigung zu vermeiden.

Das System kann insbesondere eine Lampe oder einen Teil einer Lampe darstellen. Die Leiterplatte kann, ggf. zusammen mit anderen daran befestigten oder befestigbaren Elementen, als ein Leuchtmodul ausgestaltet sein. Die Auflage kann auch eine Leuchte oder ein Teil davon sein.

Die Aufgabe wird auch gelöst durch ein Verfahren zum Befestigen einer Leiterplatte wie oben beschrieben an einer Auflage wie oben beschrieben, wobei das mindestens eine Befestigungsgegenelement der Auflage mittels einer Steck-Bewegung oder einer Steck/Dreh-Bewegung in ein passendes Befestigungselement der Leiterplatte kraftschlüssig und/oder formschlüssig eingesetzt wird. Ein solche Befestigung kann insbesondere werkzeuglos erfolgen.

Die Steck/Dreh-Bewegung kann beispielsweise durch ein Einstecken mindestens eines Befestigungsstifts (der Leiterplatte und/oder der Auflage) in einen jeweiligen Augenbereich eines passenden Schlüssellochs (der Auflage und/oder der Leiterplatte) und folgendes Verdrehen des mindestens eines Befestigungsstifts in den Bartbereich des Schlüssellochs durchgeführt'werden. In dem Bartbereich kann der Befestigungsstift z.B. durch eine federnde Klammer insbesondere lösbar verrastet werden, so dass ein unbeabsichtigtes Lösen der Steck/Dreh-Bewegung verhindert wird.

Die Steck-Bewegung kann beispielsweise durch ein Einstecken mindestens eines Befestigungselements (der Leiterplatte und/oder der Auflage) in ein jeweiliges Loch, insbesondere Langloch (der Auflage und/oder der Leiterplatte), durchgeführt werden. In dem Loch kann das Befestigungselement z.B. lösbar oder unlösbar verrastet werden, so dass ein unbeabsichtigtes Lösen der Steck-Bewegung verhindert wird.

Insbesondere oder eigenständig kann die Aufgabe gelöst werden durch ein Verfahren zum zumindest mittelbaren Befestigen einer mit mindestens einer Halbleiterlichtquelle (insbesondere Leuchtdiode) bestückten Leiterplatte an einer Auflage (insbesondere Treibergehäuse), wobei das Verfahren mindestens die folgenden Schritte aufweist:
- Aufstecken eines Kühlkörpers auf die Auflage so, dass mindestens ein von der Auflage vorstehender elektrisch leitfähiger Befestigungsstift, welcher mit einer elektrischen Versorgung verbunden ist, durch den Kühlkörper ragt,
- Aufsetzen der Leiterplatte auf den Kühlkörper so, dass der mindestens eine durch den Kühlkörper hindurchragende Befestigungsstift zumindest teilweise in eine zugehörige Aussparung (insbesondere Schlüsselloch) der Leiterplatte ragt,
- Befestigen des mindestens einen Befestigungsstifts in der zugehörigen Aussparung, so dass mindestens ein Befestigungsstift mit mindestens einer Halbleiterlichtquelle elektrisch verbunden ist.

Es ist eine Ausgestaltung, dass vor dem Schritt des Aufsetzens der Leiterplatte auf den Kühlkörper ein Schritt: Aufbringen einer thermischen Lage, insbesondere festen thermischen Lage auf den Kühlkörper; vorangeht.

Es ist noch eine Ausgestaltung, dass:
- die mindestens eine Aussparung in Form eines Schlüssellochs vorliegt,
- das Befestigen des mindestens einen Befestigungsstifts in dem zugehörigen Schlüsselloch mittels einer Drehbewegung zwischen der Auflage und der Leiterplatte durchgeführt wird und
- zusätzlich ein Schritt eines Fixierens einer relativen Drehlage zwischen der Auflage und der Leiterplatte mittels eines Fixierelements durchgeführt wird.

In den folgenden Figuren wird ein nicht beanspruchtes Ausführungsbeispiel schematisch genauer beschrieben. Dabei können zur Übersichtlichkeit gleichen oder gleichwirkende Elemente mit gleichen Bezugszeichen versehen sein.
- Fig.1: zeigt in einer Ansicht von schräg oben eine Leiterplatte;
- Fig.2: zeigt die Leiterplatte in einer Ansicht von schräg unten;
- Fig.3: zeigt die Leiterplatte in einer Seitenansicht;
- Fig.4: zeigt in einer Ansicht von schräg oben die nun mit einer Abdeckung vorderseitig abgedeckte Leiterplatte;
- Fig.5: zeigt in einer Ansicht von schräg oben die Leiterplatte oberhalb einer Auflage für die Leiterplatte;
- Fig.6: zeigt die Auflage in einer Draufsicht auf deren Auflagefläche;
- Fig.7: zeigt in einer Ansicht von schräg oben ein System aus der Leiterplatte und der Auflage in einem zusammengebauten Zustand, wobei die Auflage teilweise durchsichtig angezeigt ist; und
- Fig.8: zeigt die Auflage als Schnittdarstellung in Draufsicht.
- Fig.11: zeigt in einer Ansicht von schräg oben eine Leuchtvorrichtung;
- Fig.12: zeigt in einer Schrägansicht die Leuchtvorrichtung in einer Explosionsdarstellung;
- Fig.13: zeigt in einer Ansicht von schräg oben eine Leiterplatte der Leuchtvorrichtung;
- Fig.14: zeigt in einer Ansicht von schräg oben eine Explosionsdarstellung eines Treibergehäuses und eines Kühlkörpers die Leuchtvorrichtung;
- Fig.15: zeigt in einer Schrägansicht das Treibergehäuse und den Kühlkörper der Leuchtvorrichtung in einem zusammengesetzten Zustand;
- Fig.16: zeigt in einer Schrägansicht das Treibergehäuse und den Kühlkörper der Leuchtvorrichtung in einem zusammengesetzten Zustand mit einer zusätzlichen thermischen Lage;
- Fig.17: zeigt in einer Ansicht von schräg vorne die Leuchtvorrichtung in einem zusammengesetzten, aber noch nicht befestigten Zustand;
- Fig.18: zeigt in einer Ansicht von schräg vorne die Leuchtvorrichtung in dem befestigten Zustand; und
- Fig.19: zeigt in einer Ansicht von schräg vorne die Leuchtvorrichtung in einem fixierten Zustand.

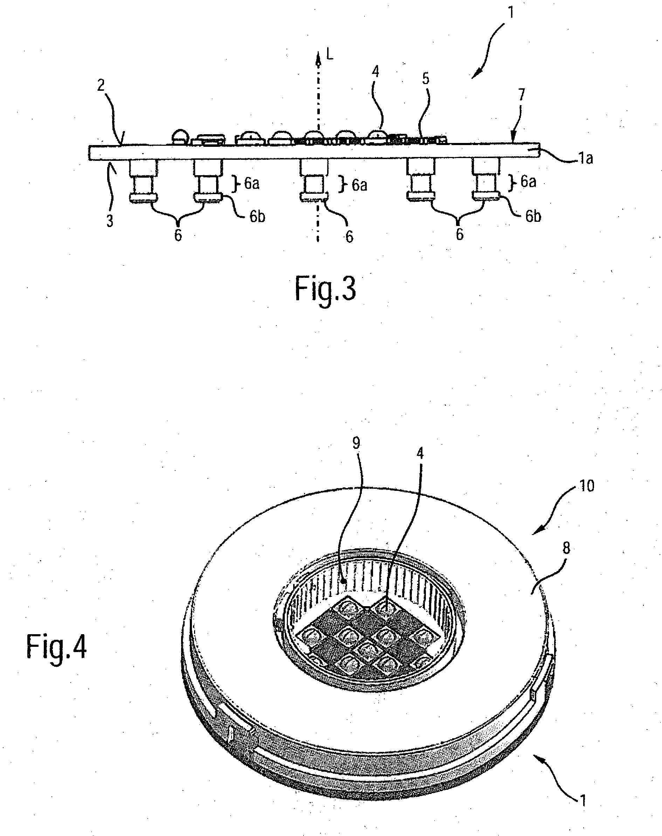

**Fig.1** zeigt in einer Ansicht von schräg oben eine Leiterplatte 1 mit einem kreisrunden Grundkörper oder Substrat 1a. **Fig.2** zeigt die Leiterplatte 1 von schräg unten. **Fig.3** zeigt die Leiterplatte 1 in einer Seitenansicht.

Die Vorderseite 2 der Leiterplatte 1 bzw. des Substrats 1a ist auch hier beispielhaft in einem zentralen Bereich mit mehreren Leuchtdioden 4 und um die Leuchtdioden 4 herum mit mehreren, auch unterschiedlichen, elektronischen Bauelementen 5 bestückt. Die Vorderseite 2 ist dazu mit einer (nicht gezeigten) Leiterbahn- oder Leitungsstruktur versehen, welche die elektrisch betreibbaren Elemente 4, 5 miteinander elektrisch verbindet. Jedoch fehlt nun das Steckverbindungselement 106.

Dafür sind an der Rückseite 3 rotationssymmetrisch zu einer Längsachse L beispielhaft fünf Befestigungselemente in Form von senkrecht stehenden metallischen Stiften 6 angeordnet. Die metallischen Stifte 6 sind durch die Leiterplatte 1 bzw. durch das Substrat 1a durchgeführt, wobei ihre vorderseitige Oberfläche 7 flächenbündig zu der Vorderseite 2 des Substrats 1a liegt.

Die Oberfläche 7 der Stifte 6 kann elektrisch mit der Leiterbahnstruktur oder direkt mit einem der elektronischen Bauelemente 5 oder einer der Leuchtdioden 4 verbunden sein, z.B. durch ein Verlöten, Drahtverbinden usw. Mittels der Stifte 6 wird somit erstens eine elektrische Verbindung zwischen der Vorderseite 2, insbesondere den Leuchtdioden 4, und der Rückseite 3 geschaffen (die Stifte 6 wirken somit als Durchkontaktierungen).Die Stifte 6 dienen in die rückwärtige Richtung als elektrische Stiftkontakte. Zweitens dienen die Stifte 6 als mechanische Befestigungselemente. Mittels einer geeigneten elektrischen Belegung der Stifte 6 können die Leuchtdioden 4 entsprechend betrieben werden.

Die Stifte 6 weisen an ihrem rückwärtig vorspringenden Abschnitt einen ringförmig umlaufenden Rücksprung 6a, insbesondere eine Ringnut, auf, welche in die ansonsten kreiszylinderförmige Form der Stifte 6 eingebracht ist. Der Rücksprung 6a lässt einen freien Endbereich 6b des Stifts seitlich über den Rücksprung 6a überstehen. Der freie Endbereich 6b kann für eine zumindest formschlüssige, insbesondere auch kraftschlüssige, Befestigung verwendet werden.

Da das Steckverbindungselement 106 entfällt, kann die Leiterplatte 1 flacher ausgeführt werden als die Leiterplatte 101. Zudem wird keine Schraubendurchführung 107 mehr benötigt, was eine Flächenausnutzung verbessern kann. Durch die rückwärtige elektrische Kontaktierung kann ferner ein Raum seitlich der Leiterplatte 1 besser genutzt werden. Außerdem lässt sich eine Zahl der Stifte 6 einfach einstellen. Auch eine große Zahl an Stiften 6 lässt sich ohne eine Vergrößerung der Bauform an der Rückseite 3 der Leiterplatte 1 anordnen.

**Fig.4** zeigt in einer Ansicht von schräg oben ein LED-Modul 10, aufweisend die Leiterplatte 1 und eine die Vorderseite 2 der Leiterplatte 1 zumindest teilweise abdeckende Ringabdeckung 8. Die Ringabdeckung 8 deckt die elektronischen Bauelemente 5 ab, lässt jedoch eine zentrale Aussparung für die Leuchtdioden 4 frei. Eine Innenwand 9 der Ringabdeckung 8 dient als eine Reflektorwand für die Leuchtdioden 4.

Die Ringabdeckung 8 weist nun weder Schraublöcher noch Befestigungsschrauben auf, so dass die Oberfläche der Ringabdeckung 8 glatt ist und damit gestalterisch vorteilhaft. Die Rindabdeckung 8 kann z.B. an die Leiterplatte 1 angeklebt werden.

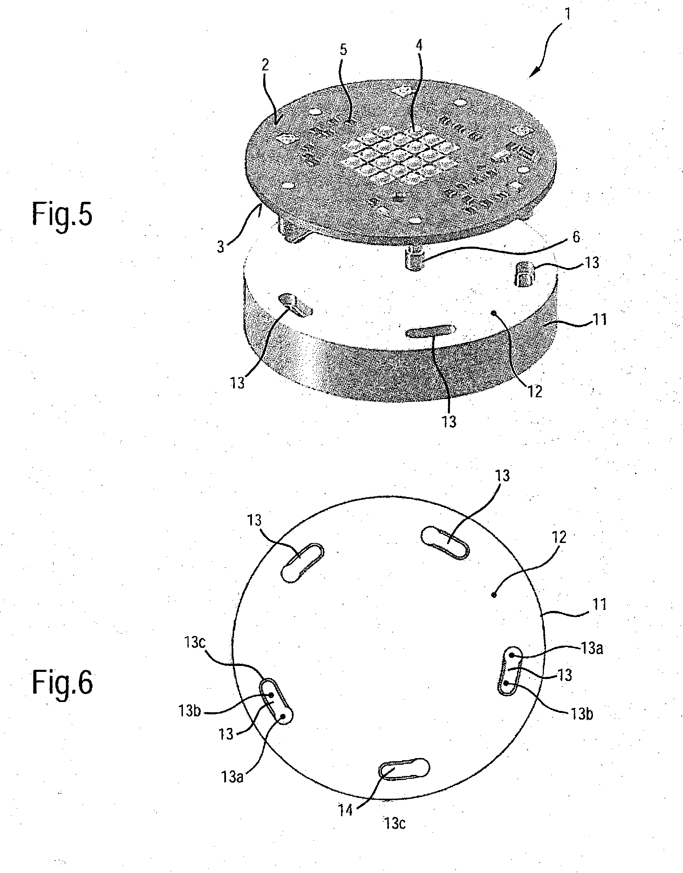

**Fig.5** zeigt in einer Ansicht von schräg oben die Leiterplatte 1 oberhalb einer Auflage 11 für die Leiterplatte 1. **Fig.6** zeigt die Auflage 11 in einer Draufsicht auf deren vorderseitige, der Leiterplatte 1 zugewandte Auflagefläche 12. Die Auflagefläche 12 dient zur Auflage der Rückseite 3 der Leiterplatte 1, und zwar direkt oder indirekt, z.B. über eine Zwischenlage (o.Abb.), insbesondere gut wärmeleitfähige Zwischenlage, wie ein TIM.

Die Auflage 11, z.B. ein dedizierter Kühlkörper, weist fünf Befestigungsgegenelemente in Form von Schlüssellöchern 13 auf, welche in Draufsicht die gleiche Anordnung aufweisen wie die Stifte 6. Die Stifte 6 der Leiterplatte 1 können somit in ein jeweiliges Schlüsselloch 13 eingeführt werden, wobei die Rückseite 3 dann flächig auf der Auflagefläche 12 aufliegt und so einen geringen thermischen Übergangswiderstand ermöglicht. Die Schlüssellöcher 13 sind in Umfangsrichtung gebogen, um eine einfache Steck/Dreh-Befestigung zu ermöglichten.

Ein Augenbereich 13a der Schlüssellöcher 13 ist dazu so dimensioniert, dass ein Stift 6 der Leiterplatte 1 darin eingeführt werden kann. Der an den Augenbereich 13a anschließende Bartbereich 13b ist auf einer Höhe, welche einer Position des Rücksprungs 6a der Stifte 6 entspricht, verengt, z.B. durch, seitlich angeordnete Längsvorsprünge 13c. Bei einem Eindrehen der Stifte 6 in den zugehörigen Bartbereich 13b werden diese durch die Längsvorsprünge 13c in Richtung der Längsachse L zumindest formschlüssig in dem Schlüsselloch 13 zurückgehalten.

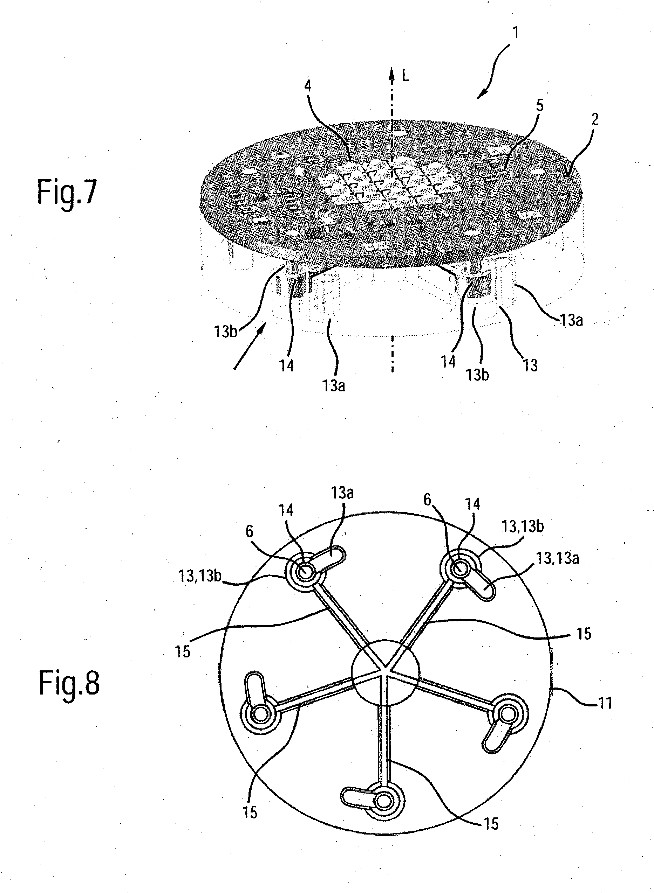

**Fig.7** zeigt in einer Ansicht von schräg oben ein System aus der Leiterplatte 1 und der Auflage 11 in einem zusammengesetzten Zustand, wobei die Auflage 11 teilweise durchsichtig gezeigt ist. Dabei kann anstelle der Leiterplatte 1 auch das LED-Modul 10 an der Auflage 11 befestigt sein.

Die Stifte 6 sind nun in den zugehörigen Bartbereich 13b eingedreht worden. In dem jeweiligen Bartbereich 13b befindet sich eine in Richtung des Augenbereichs 13a geöffnete elastische Klammer 14. Bei einem Eindrehen des Stifts 6 in den Bartbereich 13b rastet der Stift 6 folglich in der Klammer 14 ein und wird dort mit einer Andruckkraft gehalten. Dadurch kann ein Herausgleiten des Stifts 6 aus dem Bartbereich 13b zurück in den Augenbereich 13a verhindert werden. Diese Verrastung ist lösbar, und die Stifte 6 können durch eine ausreichend hohe Rückdrehkraft aus den Klammern 14 gelöst werden. Dadurch, dass die Klammer 14 auf den Stift 6 die Andrückkraft oder Anpresskraft ausübt, ergibt sich auch ein guter elektrischer Kontakt zwischen diesen beiden Elementen 6, 14.

**Fig.8** zeigt die Auflage 11 als Schnittdarstellung in Draufsicht. Jede der Klammern 14 ist über eine elektrische Leitung 15 gemeinsam oder individuell mit einer elektrischen Versorgung, z.B. mit einem Ausgang eines Treibers oder mit einer Netzversorgung, elektrisch verbunden. In dem gezeigten Fall verlaufen die elektrischen Leitungen 15 von der Mitte der Auflage 11 sternförmig zu den Klammern 14.

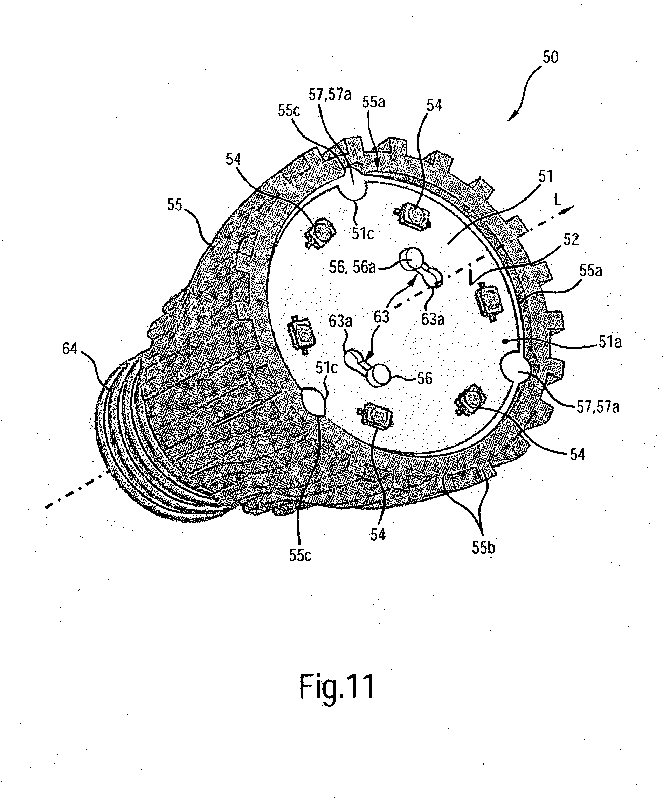

**Fig.11** zeigt in einer Ansicht von schräg oben eine Leuchtvorrichtung in Form einer LED-Glühlampen-Retrofitlampe 50. Eine Lichtabstrahlung der Lampe 50 wird durch ein Vorhandensein von Leuchtdioden 54 als den Halbleiterlichtquellen ermöglicht, welche mit ihrer optischen Hauptachse in Richtung einer Symmetrieachse oder Längsachse L der Lampe 50 ausgerichtet sind. Die Leuchtdioden 54 strahlen somit im Wesentlichen in einen vorderen oder oberen Halbraum. Die Leuchtdioden 54 sind winkelsymmetrisch um die Längsachse L der Lampe 50 auf einer Vorderseite 52 einer kreisscheibenförmigen Leiterplatte 51 bzw. eines kreisscheibenförmigen Substrats 51a der Leiterplatte 51 aufgebracht. Auf der Vorderseite der Leiterplatte 51 bzw. des Substrats 51a befindet sich eine Leiterbahnstruktur (o. Abb.) welche die Leuchtdioden 54 miteinander und/oder mit einem elektrischen Anschlussbereich an der Leiterplatte 51 verbindet.

Ein (in Bezug auf die Längsrichtung L) oberer Seitenbereich oder Mantel der Lampe 50 wird aus einem Kühlkörper 55 gebildet. Der Kühlkörper 55 weist als eine Aufnahme 55a eine obere oder vordere Aussparung auf, in welche die Leiterplatte 51 eingesetzt ist. Der Kühlkörper 55 kann insbesondere aus einem gut wärmeleitenden Material mit einer Wärmeleitfähigkeit λ von mehr als 15 W/(m·K) bestehen, vorzugsweise mit λ ≥ 150 W/(m·K). Der Kühlkörper 55 mag insbesondere aus Aluminium, Kupfer oder Legierungen davon bestehen. An seiner äußeren Mantelfläche weist der Kühlkörper 55 winkelsymmetrisch um die Längsachse L angeordnete, längsgerichtete bzw. vertikal ausgerichtete Kühlrippen 55b auf. An einem rückwärtigen Ende der Lampe 50 befindet sich ein Sockel 64 zur mechanischen und elektrischen Verbindung der Lampe 50 mit einer passenden Fassung, beispielsweise einer Leuchte. Der Sockel 64 ist hier rein beispielsweise als ein Schraubsockel in Form eines Edison-Sockels ausgebildet.

Die Lampe 50 weist ferner, falls die Leuchtdioden 54 nicht mit dem über den Sockel 64 abgreifbaren 'elektrischen Signal direkt betreibbar sind, einen Treiber (o. Abb.) auf, welcher typischerweise das über den Sockel 64 abgreifbare elektrisches Signal in ein zum Betreiben der Leuchtdioden 54 vorgesehenes elektrisches Signal (Treibersignal) umwandelt und somit die Leuchtdioden 54 speist. Der Treiber stellt, ggf. zusammen mit dem Sockel 64, also die elektrische Versorgung der Leuchtdioden 54 dar.

Die Leiterplatte 51 weist zwei winkelsymmetrisch zu der Längsachse L in das Substrat 51a eingebrachte Befestigungselemente in Form von Aussparungen, speziell Aussparungen in Form von Schlüssellöchern 63, auf. Die Schlüssellöcher 63 erstrecken sich über die gesamte Höhe des Substrats 51a, sind also durchgehend in die Leiterplatte 51 bzw. deren Substrat 51a eingebracht. Die Leiterplatte 51 wird mittels zweier als passende Befestigungsgegenelemente vorgesehenen Befestigungsstifte 56, welche in die Schlüssellöcher 63 eingreifen, an der Lampe 50 befestigt. Falls die Leiterplatte 51 als eine Metallkernleiterplatte ausgestaltet ist, kann können die Schlüssellöcher 63 so ausgestaltet sein, dass der Metallkern die Befestigungsstifte 56 nicht kontaktiert. Alternativ mögen nur die Köpfe 56a der Befestigungsstifte 56, welche weiter unten genauer beschrieben sind, außenseitig elektrisch leitfähig sein, aber nicht deren stiftartige Stiele, welche z-B. mit einer elektrisch nichtleitenden Beschichtung versehen sein können.

Um ein unbeabsichtigtes Lösen der Leiterplatte 51 von den Befestigungsstiften 56 aufgrund einer ungewollten Drehbewegung der Leiterplatte 51 relativ zu den Befestigungsstiften 56 zu verhindern, sind die Leiterplatte 51 und der Kühlkörper 55 durch einen Fixierring 57 miteinander fixiert. Der Fixierring 57 verhindert eine relative Drehbewegung der Leiterplatte 51 und des Kühlkörpers 55, wobei die Befestigungsstifte 56 bezüglich des Kühlkörpers 55 drehinvariant sind. Der Fixierring 57 weist dazu drei winkelsymmetrisch angeordnete Verbreiterungsbereiche 57a auf, welche in passende seitliche Rücksprünge 51c der Leiterplatte bzw. 55c des Kühlkörpers 55 eingreifen.

Die Leiterplatte 51 kann von einer zumindest teilweise lichtdurchlässigen Abdeckung, z.B. einem (beispielsweise kugelkalottenförmigen Kolben (o. Abb.)) überwölbt sein. Der Kolben kann beispielsweise an einer Vorderseite des Kühlkörpers 55 befestigt werden.

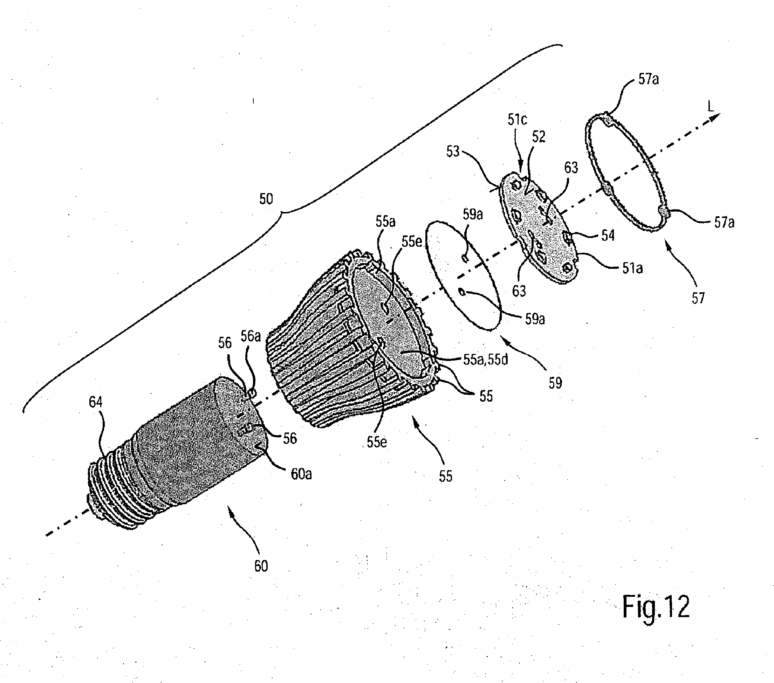

**Fig.12** zeigt die Lampe 50 in einer Explosionsdarstellung. Die Lampe 50 mag aus lediglich fünf, einteiligen oder mehrteiligen, vorgefertigten Elementen zusammengesetzt werden. Diese Elemente umfassen hier: den Fixierring 57, die bestückte Leiterplatte 51, eine Zwischenlage 59, den Kühlkörper 55, sowie ein Treibergehäuse 60 zur Aufnahme des Treibers (o. Abb.). Das Treibergehäuse 60 dient als die, hier mittelbare oder indirekte, Auflage für die Leiterplatte 51. Das Treibergehäuse 60 weist eine kreiszylinderförmige Grundform auf. Eine vordere Deckfläche 60a des Treibergehäuses trägt die Befestigungsstifte 56 während das rückwärtige Ende (das gegen die Richtung der Längsachse L ausgerichtete Ende) durch den Sockel 64 abgedeckt ist.

Der Kühlkörper 55 weist in einer bodenseitigen Auflagefläche 55d der Aufnahme 55a zwei kreisrunde Durchführungen 55e auf, durch welche die Befestigungsstifte 56 geführt werden können, ohne den Kühlkörper 55 zu kontaktieren.

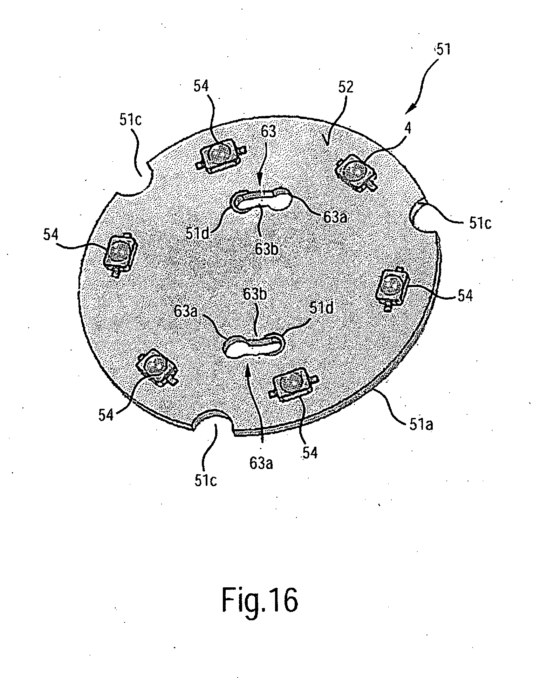

Die Zwischenlage 59 besteht aus einem elastischen Material und weist ebenfalls zwei Durchführungen 59a auf, welche deckungsgleich zu den Durchführungen 55e des Kühlkörpers 55 und den Befestigungsstiften 56 positioniert sind. Deckungsgleich dazu wiederum sind die Schlüssellöcher 63, insbesondere deren Augenbereiche 63a (siehe Fig. 16), in der Leiterplatte 51 positioniert. Die Zwischenlage 59 besteht vorzugsweise aus einem gut wärmeleitenden Material, insbesondere einem thermischen Schnittstellenmaterial TIM ("Thermal Interface Material").

Bei einem Zusammensetzen der einzelnen Elemente 60, 55, 59, 51 und 57 durch eine lineare Bewegung in Ausrichtung der Längsachse L werden die Befestigungsstifte 56 durch die passenden Durchführung 55e, 59a sowie die Augenbereiche 63a der Schlüssellöcher 63 durchgesteckt, wie im Folgenden genauer erläutert wird.

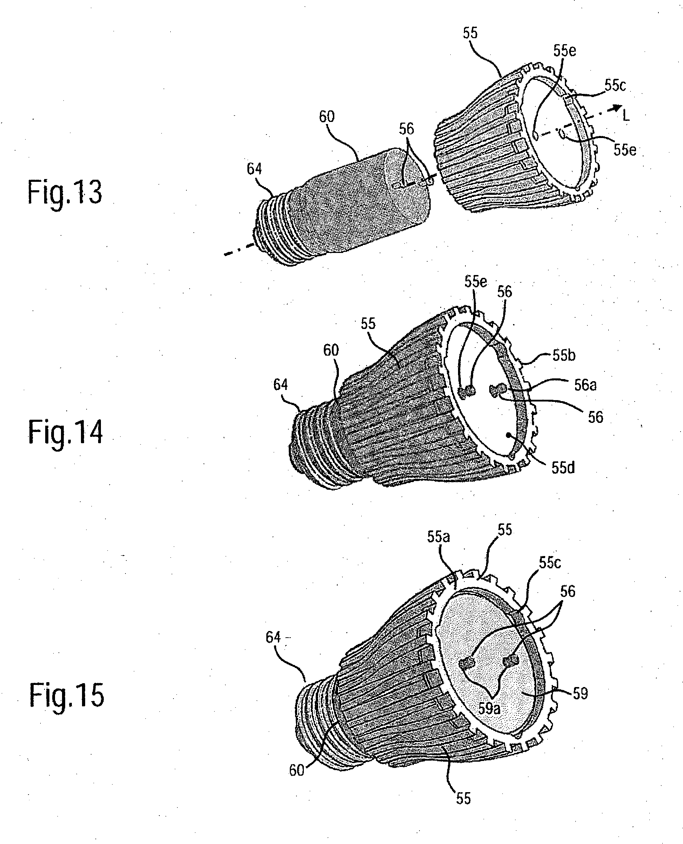

**Fig.13** zeigt dazu zunächst das als die Auflage dienende Treibergehäuse 60 mit dem Kühlkörper 55. In einem ersten Montageschritt kann beispielsweise der Kühlkörper 55, welcher eine rückwärtige kreiszylinderförmige Aussparung (o. Abb.) aufweist, durch eine Bewegung entlang der Längsachse L auf das Treibergehäuse 60 aufgesetzt werden. In anderen Worten kann das Treibergehäuse 60 in die rückseitig offene Aussparung oder Aufnahme des Kühlkörpers 55 eingesteckt werden, wobei der zusammengesetzte oder eingesteckte Zustand in Fig.14 gezeigt ist. Die rückwärtige Aussparung des Kühlkörpers 55 ist dabei so bemessen, dass das Treibergehäuse 60 insbesondere mit einem nur geringen oder sogar auch ohne einen Spalt in die Aussparung eingesteckt werden kann. Dadurch wird eine effektive Wärmeableitung von dem Treibergehäuse 60 auf den Kühlkörper 55 und damit eine wirksame Kühlung des in dem Treibergehäuse 60 untergebrachten Treibers ermöglicht.

Ein Zwischenraum zwischen dem Treibergehäuse 60 und dem Kühlkörper 55 kann vor oder nach einem Zusammensetzen mit einem vorzugsweise flüssigen oder pastösen Wärmeleitmaterial (Wärmeleitpaste, Wärmeleitkleber usw.) aufgefüllt werden, um eine noch bessere Wärmeleitung zwischen dem Treibergehäuse 60 und dem Kühlkörper 55 zu ermöglichen.

Es können Mittel vorgesehen sein, um eine relative Winkellage des Treibergehäuses 60 relativ zu dem Kühlkörper 55 in Bezug auf die Längsachse sicherzustellen, beispielsweise vertikale bzw. in Längsrichtung ausgerichtete Führungsmittel, beispielsweise ein Führungssteg in einem der Elemente 55, 60 und eine passende Längsnut in dem anderen Element 55 bzw. 60. Dadurch kann sichergestellt werden, dass die Befestigungsstifte 56 in dem zusammengesteckten oder zusammengesetzten Zustand einen ausreichenden Abstand zu dem Kühlkörper 55 einnehmen. Alternativ können die Durchführungen 55e mit einem elektrischen Isoliermaterial ausgekleidet sein, z.B. einer Plastikhülse.

**Fig.15** zeigt einen weiteren Montageschritt, bei dem zusätzlich zu dem in Fig.14 gezeigten Zustand die Zwischenlage 59 auf die Auflagefläche 55d des Kühlkörpers 55 aufgesetzt worden ist. Die Befestigungsstifte 56 ragen durch die Zwischenlage 59 nach vorne heraus. Die Zwischenlage 59 kann insbesondere aus einem gut wärmeleitenden Material bestehen, insbesondere einem TIM. Das Material der Zwischenlage 59 ist ferner bevorzugt elektrisch isolierend.

In einem folgenden Montageschritt wird die Leiterplatte 51 auf die Zwischenlage 59 in die Aufnahme 55a des Kühlkörpers 55 eingesetzt, wie im Folgenden genauer erklärt wird.

**Fig.16** zeigt dazu die Vorderseite 52 der Leiterplatte 51 in einer detaillierteren Darstellung. Die Schlüssellöcher 63 weisen jeweils einen Augenbereich 63a auf, durch welchen ein jeweiliger Befestigungsstift 56 hindurch gesteckt werden kann. Da der Befestigungsstift 56 an seinem freien Ende eine seitliche Verbreiterung ("Kopf") 56a aufweist, kann durch eine folgende Drehung der Leiterplatte 51 in Bezug auf die Befestigungsstifte 56 der jeweilige Befestigungsstift 56 aus dem Augenbereich 63a in einen Bartbereich 63b des Schlüssellochs 63 verschoben werden. Da der Bartbereich 63b schmaler ausgebildet ist als der Augenbereich 63a, wird die Leiterplatte 51 zumindest formschlüssig in Längsausrichtung L durch die Befestigungsstifte 56 gehalten. An den Enden der Bartbereiche 63b befindet sich oberseitig des Substrats 51 bzw. der Leiterplatte 51 direkt an die Kontur des Schlüssellochs 63 als solchem anschließend ein Lötbereich 51d. Der Lötbereich 51d weist ein Lötmaterial auf, insbesondere eine Schicht davon. Das Lötmaterial kann insbesondere eine Zinn/Blei-Mischung sein, und der Lötbereich 51 kann insbesondere ein Lötmaterial gemäß dem ASTM International-Standard B579-73(2004) "Standard Specification for Electrodeposited Coatings of Tin-Lead Alloy" (sog. "Solder Plate") aufweisen.

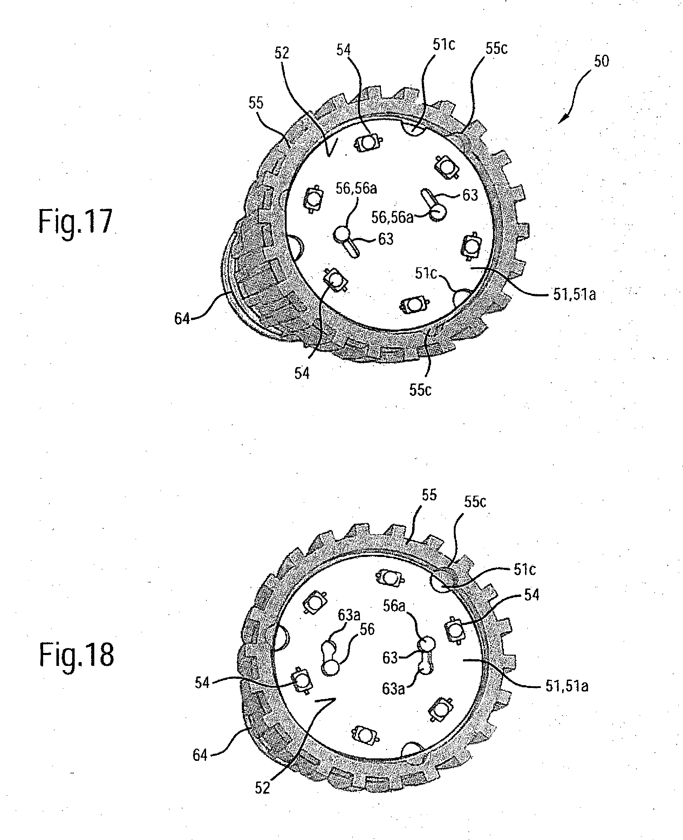

**Fig.17** zeigt in einer Ansicht von schräg vorne die Lampe 50, bei welcher in dem gezeigten eingesteckten Zustand die Befestigungsstifte 56 durch die Augenbereiche 63a der Schlüssellöcher 63 gesteckt sind, und zwar so, dass die seitlich verbreiterten Endbereiche oder Köpfe 56a der Befestigungsstifte 56 nicht vollständig über das Substrat 51a der Leiterplatte hinausschauen.

Zum Übergang des in Fig.17 gezeigten zusammengesteckten Zustands in den in **Fig.18** gezeigten befestigten Zustand der Lampe 50 kann die Leiterplatte 51 insbesondere leicht nach unten gedrückt werden, um den seitlich verbreiterten Kopf 56a der Befestigungsstifte 56 in eine Position oberhalb des Substrats 51a zu bringen. Dies wird dadurch ermöglicht, dass die Zwischenlage 59 elastisch oder rückfedernd ausgebildet und mit einer ausreichenden Höhe ausgewählt ist.

Danach kann die Leiterplatte 51 gegen die Befestigungsstifte 56 verdreht werden, hier: im Uhrzeigersinn, so dass die Befestigungsstifte 56 in den Bartbereich 63b der Schlüssellöcher gleiten. Dabei kommen die Köpfe 56a auf dem jeweiligen Lötbereich 51d zum liegen. Der Lötbereich dient somit als ein Befestigungsbereich.

Wird die Leiterplatte 51 dann nicht mehr in Richtung der Zwischenlage 59 gedrückt, drängt die Zwischenlage 59 die Leiterplatte 51 leicht gegen die Köpfe 56a der Befestigungsstifte 56. Bezüglich der Längsausrichtung L greifen die Befestigungsstifte 56 in die Schlüssellöcher 63 so ein, dass die Leiterplatte 51 durch die Befestigungsstifte 56 kraft- und formschlüssig gehalten wird. Mittels der gut wärmeleitenden Zwischenlage 59 wird ferner eine gute Wärmeabfuhr der von den Leuchtdioden 54 erzeugten Abwärme zu dem Kühlkörper 55 ermöglicht.

In dem in Fig.18 gezeigten befestigten Zustand kommen auch die Rücksprünge 55c des Kühlkörpers 55 und 51c der Leiterplatte 51 seitlich miteinander in Deckung und bilden dadurch einen lokalen Aufnahmeraum für die Verbreiterungsbereiche 57a des Fixierrings 57.

In einem folgenden optionalen Lötschritt kann durch eine zumindest lokale Erwärmung der Leiterplatte 51 und/oder des Kopfs 56a des Befestigungsstifts 56 das in dem Lötbereich 51d befindliche Lötmaterial oder Lot zum Schmelzen gebracht werden, so dass dieses die Leiterplatte 51 und zumindest eine Unterseite des Kopfs 56a über eine Lötverbindung stoffschlüssig miteinander verbindet. Dadurch wird ein sicherer elektrischer Kontakt zwischen dem Befestigungsstift 56 und einer mit dem jeweiligen Lötbereich 51d elektrisch verbundenen bzw. daran anschließenden Leiterbahnstruktur und damit der Leuchtdioden 54 erreicht.

Alternativ kann das in dem Lötbereich 51d befindliche Lötmaterial ohne ein Verlöten dazu verwendet werden, einen großflächigen und elektrisch gut leitenden Kontakt, insbesondere Presskontakt, mit dem Kopf 56a des Befestigungsstifts 56 zu ermöglichen.

Der Lötbereich 51d der Leiterplatte 51 kann mit der Leiterbahnstruktur verbunden sein bzw. einen Teil davon darstellen.

In noch einer alternativen Ausführung werden die Befestigungsstifte 56 nicht über die Schlüssellöcher 63 mit der Leiterbahnstruktur elektrisch verbunden. Vielmehr können die Befestigungsstifte 56 beispielsweise über einen Draht mit der Leiterbahnstruktur oder direkt mit mindestens einer der Leuchtdioden 54 verbunden werden, d.h., z.B. durch ein "Drahtbonden".

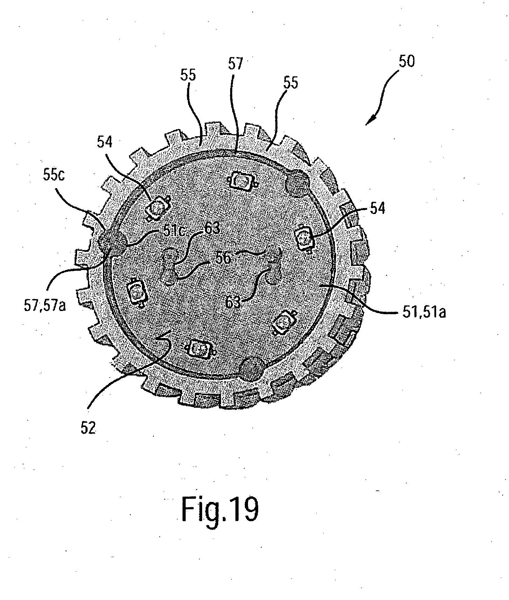

**Fig.19** zeigt die Lampe 50 in einem vollständig zusammengebauten und fixierten Zustand, wobei nun der Fixierring zwischen die Leiterplatte 51 und den Kühlkörper 55 eingesetzt worden ist, und zwar mit seinen Verbreiterungsbereichen 57a in den jeweiligen, durch die Rücksprünge 51c und 55c geschaffenen Aufnahmeraum.

In noch einem weiteren Schritt kann nun ein lichtdurchlässiger, z.B. milchig weißer Kolben auf die Lampe 50 aufgesetzt werden, welcher die Leiterplatte 51 überwölbt.

Die Leiterplatte 51 liegt insgesamt mittelbar bzw. indirekt über die Zwischenlage 59 und den Kühlkörper 55 auf der als Auflagefläche dienenden Deckfläche 60a des Treibergehäuses 60 auf.

So kann die Leiterplatte außer der kreisförmigen oder scheibenförmigen Grundform auch jede andere Grundform aufweisen, z.B. eckig oder mit einer freiförmigen Seitenkontur.

Zudem mag die Abdeckung vorhanden sein oder nicht. Falls die Abdeckung vorhanden ist oder die Leiterplatte ein Leuchtmodul aufweist, welches die Leiterplatte und vorteilhafterweise zumindest die Abdeckung aufweist, kann die Abdeckung die Leiterplatte ganz oder teilweise überdecken. Die Abdeckung mag dann zumindest teilweise lichtdurchlässig sein. Die Abdeckung kann einteilig oder mehrteilig aufgebaut sein.

Die Leiterplatte 1 und die Auflage 11 ebenso wie die Leiterplatte 51 und das Treibergehäuse 60 können einen Teil einer Lampe darstellen. Die Lampe kann als Bestandteile unter anderem ein Treibergehäuse (alternativ ist in dem Kühlkörper eine Treiberkavität vorhanden) und/oder einen Sockel (z.B. einen Schraubsockel oder einen Stecksockel usw.) aufweisen.

Die Halbleiterlichtquellen können allgemein z.B. mit einer Netzspannung oder einer umgewandelten, insbesondere niedrigeren Spannung betrieben werden.

Auch die Auflage kann jedes geeignete Objekt' sein und ist nicht auf eine bestimmte Grundform beschränkt. So kann die Auflage außer einem dedizierten Kühlkörper auch ein Treibergehäuse oder ein anderes Gehäuse einer Lampe sein. Die Auflage kann auch eine Leuchte oder ein Teil eines Leuchtensystems sein.

Darüber hinaus können anstelle von Stiften auch Haken, Nasen usw. verwendet werden.

Die Zahl der Befestigungselemente ist nicht beschränkt und kann z.B. auch nur ein Befestigungselement, z.B. in einer zentralen Position der Leiterplatte, umfassen.

Die Auflage kann mehr Befestigungsgegenelemente umfassen als die Leiterplatte Befestigungselemente aufweist. So kann die Auflage auch für mehrere Arten von Leiterplatten oder Anordnungen (Zahl und/oder Position) von Befestigungselementen verwendet werden.

Ferner mögen auch die Stifte (oder andere vorspringende Elemente) und die Aussparungen bezüglich der Leiterplatte und der Auflage vertauscht sein. So mag die Auflage die Stifte usw. aufweisen, während die Leiterplatte die Schlüssellöcher usw. aufweisen kann. Es sind auch Mischformen möglich, so dass sowohl die Auflage als auch die Leiterplatte sowohl die Stifte usw. als auch passende Schlüssellöcher usw. aufweisen können.

Zudem mag die Aussparung (als Befestigungselement oder Befestigungsgegenelement) selbst nicht elektrisch leitend sein und 'nur' als ein Durchleitungselement zum Durchleiten oder Durchführen des komplementären Befestigungsgegenelements oder Befestigungselements wirken.

Allgemein können die Ausdrücke 'Befestigungselement' und 'Befestigungsgegenelement' gegeneinander ausgetauscht werden.

### Bezugszeichenliste

- 1: Leiterplatte
- 1a: Substrat der Leiterplatte
- 2: Vorderseite der Leiterplatte
- 3: Rückseite der Leiterplatte
- 4: Leuchtdiode
- 5: elektronisches Bauelement
- 6: Stift
- 6a: Rücksprung des Stifts
- 6b: freier Endbereich des Stifts
- 7: vorderseitige Oberfläche des Stifts
- 8: Ringabdeckung
- 9: Innenwand der Ringabdeckung
- 10: LED-Modul
- 11: Auflage
- 12: Auflagefläche
- 13: Schlüsselloch
- 13a: Augenbereich des Schlüssellochs
- 13b: Bartbereich des Schlüssellochs
- 13c: Längsvorsprung des Schlüssellochs
- 14: Klammer
- 15: elektrische Leitung
- 50: Lampe
- 51: Leiterplatte
- 51a: Substrat der Leiterplatte
- 51c: Rücksprung der Leiterplatte
- 51d: Lötbereich der Leiterplatte
- 52: Vorderseite der Leiterplatte
- 53: Rückseite der Leiterplatte
- 54: Leuchtdiode
- 55: Kühlkörper
- 55a: Aussparung des Kühlkörpers
- 55b: Kühlrippe des Kühlkörpers
- 55c: Rücksprung des Kühlkörpers
- 55d: Auflagefläche des Kühlkörpers
- 55e: Durchführung des Kühlkörpers
- 55b: Mantelfläche des Kühlkörpers
- 56: Befestigungsstift
- 56a: Kopf des Stifts
- 57: Fixierring
- 57a: Verbreiterungsbereich des Fixierrings
- 59: Zwischenlage
- 59a: Durchführung
- 60: Treibergehäuse
- 60a: Deckfläche des Treibergehäuses
- 63: Schlüsselloch
- 63a: Augenbereich des Schlüssellochs
- 63b: Bartbereich des Schlüssellochs
- 64: Sockel
- 101: Leiterplatte
- 102: Vorderseite der Leiterplatte
- 103: Rückseite der Leiterplatte
- 104: Leuchtdiode
- 105: elektronisches Bauelement
- 106: Steckverbindungselement
- 107: Schraubloch
- 108: Ringabdeckung
- 109: Innenwand der Ringabdeckung
- 110: Schraubloch
- 111: Schraube
- 112: Einführöffnung
- L: Längsachse

## Patentansprüche

1. Leiterplatte, aufweisend eine Vorderseite zum Bestücken mit mindestens einer Halbleiterlichtquelle und aufweisend mindestens ein über eine Rückseite zugängliches Befestigungselement, wobei das mindestens eine Befestigungselement als ein elektrisches Durchleitungselement für mindestens eine der Halbleiterlichtquellen ausgebildet ist, **dadurch gekennzeichnet, dass** die Leiterplatte mehrere Befestigungselemente aufweist, welche kodiert ausgestaltet und/oder angeordnet sind, indem die Befestigungselemente nicht-winkelsymmetrisch angeordnet sind.

2. Leiterplatte nach Anspruch 1, wobei mindestens ein Befestigungselement als elektrisch leitfähiges Befestigungselement ausgebildet und durch die Leiterplatte durchgeführt ist.

3. Leiterplatte nach einem der vorhergehenden Ansprüche, wobei die Leiterplatte mehrere Befestigungselemente aufweist, welche symmetrisch zu einer Symmetrieachse der Leiterplatte angeordnet sind.

4. Leiterplatte nach einem der vorhergehenden Ansprüche, wobei das mindestens eine Befestigungselement jeweils einen Befestigungsbereich, insbesondere Lötbereich, aufweist.

5. Leiterplatte nach einem der vorhergehenden Ansprüche, wobei das mindestens eine Befestigungselement mindestens ein von der Rückseite vorspringendes, elektrisch leitfähiges Befestigungselement umfasst.

6. Leiterplatte nach einem der vorhergehenden Ansprüche, wobei das mindestens eine Befestigungselement mindestens einen von der Rückseite vorspringenden, elektrisch leitfähigen Befestigungsstift umfasst.

7. Leiterplatte nach einem der vorhergehenden Ansprüche, wobei das mindestens eine Befestigungselement in Form einer durch die Leiterplatte durchgeführten Aussparung ausgebildet ist.

8. Leiterplatte nach einem der vorhergehenden Ansprüche, wobei das mindestens eine Befestigungselement in Form eines Schlüssellochs vorliegt.

9. Auflage für eine Leiterplatte nach einem der vorhergehenden Ansprüche,
- wobei die Auflage mindestens eine Auflagefläche zum Auflegen der Leiterplatte aufweist,
- wobei an der Auflagefläche mindestens ein Befestigungsgegenelement zum jeweiligen Befestigen eines Befestigungselements der Leiterplatte angeordnet ist und
- wobei mindestens ein Befestigungsgegenelement als ein elektrisches Durchleitungselement ausgebildet ist.

10. Auflage nach Anspruch 9, wobei mindestens ein Befestigungsgegenelement ein elektrisch leitendes Befestigungsgegenelement ist, das mit mindestens einer elektrischen Versorgung verbunden ist.

11. Auflage nach einem der Ansprüche 9 oder 10, wobei das mindestens eine Befestigungsgegenelement in Form einer Aussparung zur Aufnahme des Befestigungselements der Leiterplatte nach einem der Ansprüche 6 bis 7 ausgebildet ist.

12. Auflage nach Anspruch 11, wobei das mindestens eine Befestigungsgegenelement in Form eines Schlüssellochs vorliegt.

13. Auflage nach einem der Ansprüche 9 bis 12, wobei das mindestens eine Befestigungsgegenelement ein Rastmittel zum lösbaren Verrasten eines eingesetzten Befestigungselements aufweist.

14. Auflage nach einem der Ansprüche 9 bis 13, wobei die Auflage als Teil eines Kühlkörpers ausgebildet ist.

15. Auflage für eine Leiterplatte nach einem der Ansprüche 1 bis 8,
- wobei die Auflage mindestens eine Auflagefläche zum zumindest mittelbaren Auflegen der Leiterplatte aufweist,
- wobei an der Auflagefläche mindestens ein Befestigungsgegenelement zum jeweiligen Befestigen eines Befestigungselements der Leiterplatte angeordnet ist und
- wobei mindestens ein Befestigungsgegenelement, ein elektrisch leitendes Befestigungsgegenelement ist, das mit mindestens einer elektrischen Versorgung funktional verbunden ist.

16. Auflage nach Anspruch 15, wobei das mindestens eine Befestigungsgegenelement mindestens einen von der Auflagefläche vorspringenden, elektrisch leitfähigen Befestigungsstift umfasst.

17. Auflage nach einem der Ansprüche 15 oder 16, wobei die Auflage ein Treibergehäuse ist.

18. System, insbesondere Lampe, mit der Leiterplatte nach einem der Ansprüche 1 bis 8 und mit der Auflage nach einem der Ansprüche 9 bis 17, wobei die Leiterplatte zumindest mittelbar an der Auflage befestigt ist, indem das mindestens eine Befestigungselement der Leiterplatte formschlüssig, stoffschlüssig und/oder kraftschlüssig in ein jeweils passendes Befestigungsgegenelement der Auflage eingreift.

19. System nach Anspruch 18, wobei zwischen der Leiterplatte und der Auflage eine thermisch leitfähige Lage eingebracht ist, wobei die thermisch leitfähige Lage mindestens eine Aussparung zur Durchführung des Befestigungselements und/oder des Befestigungsgegenelements aufweist.

20. System nach einem der Ansprüche 18 oder 19, wobei zwischen der Leiterplatte und der Auflage ein Kühlkörper eingebracht ist, wobei der Kühlkörper mindestens eine Aussparung zur Durchführung des Befestigungselements und/oder des Befestigungsgegenelements aufweist.

21. System nach Anspruch 20, wobei der Kühlkörper zumindest teilweise über die Auflage gesteckt ist.

22. System nach einem der Ansprüche 18 bis 21, wobei die Leiterplatte an einer Aufnahme des Kühlkörpers angeordnet ist.

23. System nach einem der Ansprüche 18 bis 22, wobei das System mindestens ein Fixierelement zum Fixieren einer Position der Leiterplatte aufweist.

24. Verfahren zum Befestigen einer Leiterplatte nach einem der Ansprüche 1 bis 8 an einer Auflage nach einem der Ansprüche 9 bis 17, wobei das mindestens eine Befestigungselement der Leiterplatte mittels einer Steck-Bewegung oder einer Steck/Dreh-Bewegung in ein passendes Befestigungsgegenelement der Auflage kraftschlüssig und/oder formschlüssig eingesetzt wird.

25. Verfahren zum Befestigen einer mit mindestens einer Halbleiterlichtquelle, insbesondere Leuchtdiode, bestückten Leiterplatte an einer Auflage, insbesondere Treibergehäuse, wobei das Verfahren mindestens die folgenden Schritte aufweist:
- Aufstecken eines Kühlkörpers auf die Auflage so, dass mindestens ein von der Auflage (60) vorstehender elektrisch leitfähiger Befestigungsstift , welcher mit einer elektrischen Versorgung verbunden ist, durch den Kühlkörper ragt,
- Aufsetzen der Leiterplatte auf den Kühlkörper so, dass der mindestens eine durch den Kühlkörper hindurchragende Befestigungsstift zumindest teilweise in eine zugehörige Aussparung , insbesondere Schlüsselloch, der Leiterplatte ragt,
- Befestigen des mindestens einen Befestigungsstifts in der zugehörigen Aussparung, so dass mindestens ein Befestigungsstift mit mindestens einer Halbleiterlichtquelle elektrisch verbunden ist.

26. Verfahren nach Anspruch 25, wobei:
- die mindestens eine Aussparung in Form eines Schlüssellochs vorliegt,
- das Befestigen des mindestens einen Befestigungsstifts in dem zugehörigen Schlüsselloch mittels einer Drehbewegung zwischen der Auflage und der Leiterplatte durchgeführt wird und
- zusätzlich ein Schritt eines Fixierens einer relativen Drehlage zwischen der Auflage und der Leiterplatte mittels eines Fixierelements durchgeführt wird.

## Claims

1. Printed circuit board, having a front side for population with at least one semiconductor light source and having at least one securing element accessible via a rear side, wherein the at least one securing element is embodied as an electrical through-conduction element for at least one of the semiconductor light sources, **characterized in that** the printed circuit board has a plurality of securing elements configured and/or arranged in a coded fashion by virtue of the securing elements being arranged non-angularly symmetrically.

2. Printed circuit board according to Claim 1, wherein at least one securing element is embodied as an electrically conductive securing element and led through the printed circuit board.

3. Printed circuit board according to either of the preceding claims, wherein the printed circuit board has a plurality of securing elements arranged symmetrically with respect to an axis of symmetry of the printed circuit board.

4. Printed circuit board according to any of the preceding claims, wherein the at least one securing element has in each case a securing region, in particular a soldering region.

5. Printed circuit board according to any of the preceding claims, wherein the at least one securing element comprises at least one electrically conductive securing element projecting from the rear side.

6. Printed circuit board according to any of the preceding claims, wherein the at least one securing element comprises at least one electrically conductive securing pin projecting from the rear side.

7. Printed circuit board according to any of the preceding claims, wherein the at least one securing element is embodied in the form of a cutout led through the printed circuit board.

8. Printed circuit board according to any of the preceding claims, wherein the at least one securing element is present in the form of a keyhole.

9. Support for a printed circuit board according to any of the preceding claims,
- wherein the support has at least one support area for emplacing the printed circuit board,
- wherein at least one mating securing element for respectively securing a securing element of the printed circuit board is arranged on the support area, and
- wherein at least one mating securing element is embodied as an electrical through-conduction element.

10. Support according to Claim 9, wherein at least one mating securing element is an electrically conductive mating securing element connected to at least one electrical supply.

11. Support according to either of Claims 9 and 10, wherein the at least one mating securing element is embodied in the form of a cutout for receiving the securing element of the printed circuit board according to either of Claims 6 and 7.

12. Support according to Claim 11, wherein the at least one mating securing element is present in the form of a keyhole.

13. Support according to any of Claims 9 to 12, wherein the at least one mating securing element has a latching means for releasably latching an inserted securing element.

14. Support according to any of Claims 9 to 13, wherein the support is embodied as part of a heat sink.

15. Support for a printed circuit board according to any of Claims 1 to 8,
- wherein the support has at least one support area for at least indirectly emplacing the printed circuit board,
- wherein at least one mating securing element for respectively securing a securing element of the printed circuit board is arranged on the support area, and
- wherein at least one mating securing element is an electrically conductive mating securing element functionally connected to at least one electrical supply.

16. Support according to Claim 15, wherein the at least one mating securing element comprises at least one electrically conductive securing pin projecting from the support area.

17. Support according to either of Claims 15 and 16, wherein the support is a driver housing.

18. System, in particular a lamp, comprising the printed circuit board according to any of Claims 1 to 8 and comprising the support according to any of Claims 9 to 17, wherein the printed circuit board is at least indirectly fixed to the support by virtue of the at least one securing element of the printed circuit board engaging in a positively locking manner, cohesively and/or in a force-locking manner into a respectively matching mating securing element of the support.

19. System according to Claim 18, wherein a thermally conductive layer is introduced between the printed circuit board and the support, wherein the thermally conductive layer has at least one cutout for leading through the securing element and/or the mating securing element.

20. System according to either of Claims 18 and 19, wherein a heat sink is introduced between the printed circuit board and the support, wherein the heat sink has at least one cutout for leading through the securing element and/or the mating securing element.

21. System according to Claim 20, wherein the heat sink is at least partly plugged over the support.

22. System according to any of Claims 18 to 21, wherein the printed circuit board is arranged on a receptacle of the heat sink.

23. System according to any of Claims 18 to 22, wherein the system has at least one fixing element for fixing a position of the printed circuit board.

24. Method for securing a printed circuit board according to any of Claims 1 to 8 to a support according to any of Claims 9 to 17, wherein the at least one securing element of the printed circuit board is inserted by means of a plugging movement or a plugging/rotating movement into a matching mating securing element of the support in a force-locking and/or positively locking manner.

25. Method for securing a printed circuit board populated with at least one semiconductor light source, in particular light emitting diode, to a support, in particular driver housing, wherein the method comprises at least the following steps:
- plugging a heat sink onto the support such that at least one electrically conductive securing pin which projects from the support and which is connected to an electrical supply projects through the heat sink,
- placing the printed circuit board onto the heat sink such that the at least one securing pin projecting through the heat sink projects at least partly into an associated cutout, in particular keyhole, of the printed circuit board,
- securing the at least one securing pin in the associated cutout, such that at least one securing pin is electrically connected to at least one semiconductor light source.

26. Method according to Claim 25, wherein:
- the at least one cutout is present in the form of a keyhole,
- securing the at least one securing pin in the associated keyhole is carried out by means of a rotating movement between the support and the printed circuit board, and
- a step of fixing a relative rotational position between the support and the printed circuit board is additionally carried out by means of a fixing element.

## Revendications

1. Plaquette de circuit imprimé, présentant une face avant destinée à être équipée d'au moins une source de lumière à semi-conducteur et au moins un élément de fixation accessible par une face arrière, ledit au moins un élément de fixation étant conçu comme élément conducteur électrique pour au moins une des sources de lumière à semi-conducteur, **caractérisée en ce que** la plaquette de circuit imprimé présente plusieurs éléments de fixation configurés et/ou disposés de manière codée, les éléments de fixation n'étant pas disposés suivant une symétrie angulaire.

2. Plaquette de circuit imprimé selon la revendication 1, au moins un élément de fixation étant conçu comme élément de fixation électriquement conducteur et traversant la plaquette de circuit imprimé.

3. Plaquette de circuit imprimé selon l'une des revendications précédentes, la plaquette de circuit imprimé présentant plusieurs éléments de fixation disposés symétriquement à un axe de symétrie de la plaquette de circuit imprimé.

4. Plaquette de circuit imprimé selon l'une des revendications précédentes, le au moins un élément de fixation présentant chacun une zone de fixation, en particulier une zone de brasage.

5. Plaquette de circuit imprimé selon l'une des revendications précédentes, au moins un élément de fixation comprenant au moins un élément de fixation électriquement conducteur faisant saillie de la face arrière.

6. Plaquette de circuit imprimé selon l'une des revendications précédentes, au moins un élément de fixation comprenant au moins une tige de fixation électriquement conductrice faisant saillie de la face arrière.

7. Plaquette de circuit imprimé selon l'une des revendications précédentes, au moins un élément de fixation étant conçus sous forme d'un évidement traversant la plaquette de circuit imprimé.

8. Plaquette de circuit imprimé selon l'une des revendications précédentes, le ou les éléments de fixation se présentant sous forme d'un trou de serrure.

9. Support pour une plaquette de circuit imprimé selon l'une des revendications précédentes,
- le support présentant au moins une surface de support pour supporter la plaquette de circuit imprimé,
- sur ladite surface de support étant disposé au moins un contre-élément de fixation pour la fixation respective d'un élément de fixation de la plaquette de circuit imprimé, et
- au moins un contre-élément de fixation étant conçu comme un élément conducteur électrique.

10. Support selon la revendication 9, au moins un contre-élément de fixation étant un contre-élément de fixation électriquement conducteur connecté à au moins une alimentation électrique.

11. Support selon l'une des revendications 9 ou 10, le ou les contre-éléments de fixation étant conçus sous forme d'un évidement servant à recevoir l'élément de fixation de la plaquette de circuit imprimé selon l'une des revendications 6 à 7.

12. Support selon la revendication 11, le ou les contre-éléments de fixation se présentant sous forme d'un trou de serrure.

13. Support selon l'une des revendications 9 à 12, le au moins un contre-élément de fixation présentant un moyen d'encliquetage pour verrouiller de manière amovible un élément de fixation inséré.

14. Support selon l'une des revendications 9 à 13, le support étant conçu comme élément d'un dissipateur de chaleur.

15. Support pour une plaquette de circuit imprimé selon l'une des revendications 1 à 8,
- le support présentant au moins une surface de support pour supporter au moins indirectement la plaquette de circuit imprimé,
- sur ladite surface de support étant disposé au moins un contre-élément de fixation pour la fixation respective d'un élément de fixation de la plaquette de circuit imprimé, et
- au moins un contre-élément de fixation étant un contre-élément de fixation électriquement conducteur connecté fonctionnellement à au moins une alimentation électrique.

16. Support selon la revendication 15, le au moins un contre-élément de fixation comprenant au moins une tige de fixation électriquement conductrice faisant saillie de la surface de support.

17. Support selon l'une des revendications 15 ou 16, le support étant un boîtier d'excitateur.

18. Système, en particulier lampe, comprenant la plaquette de circuit imprimé selon l'une des revendications 1 à 8 et le support selon l'une des revendications 9 à 17, la plaquette de circuit imprimé étant fixée au moins indirectement au support, le au moins unélément de fixation de la plaquette de circuit imprimé étant engagés par complémentarité de forme et/ou par liaison de matière et/ou à force dans un contre-élément de fixation correspondant du support.

19. Système selon la revendication 18, une couche conductrice de chaleur étant intercalée entre la plaquette de circuit imprimé et le support, ladite couche conductrice de chaleur présentant au moins un évidement pour le passage de l'élément de fixation et/ou du contre-élément de fixation.

20. Système selon l'une des revendications 18 ou 19, un dissipateur de chaleur étant intercalé entre la plaquette de circuit imprimé et le support, le dissipateur de chaleur présentant au moins un évidement pour le passage de l'élément de fixation et/ou du contre-élément de fixation.

21. Système selon la revendication 20, le dissipateur de chaleur étant monté au moins partiellement sur le support.

22. Système selon l'une des revendications 18 à 21, la plaquette de circuit imprimé étant disposée sur un logement du dissipateur de chaleur.

23. Système selon l'une des revendications 18 à 22, le système comprenant au moins un élément de fixation pour fixer une position de la plaquette de circuit imprimé.

24. Procédé pour fixer une plaquette de circuit imprimé selon l'une des revendications 1 à 8 sur un support selon l'une des revendications 9 à 17, le ou les éléments de fixation de la plaquette de circuit imprimé étant engagés à force et/ou par complémentarité de forme, par un mouvement d'insertion ou un mouvement d'insertion et de rotation, dans un contre-élément de fixation correspondant du support.

25. Procédé pour fixer une plaquette de circuit imprimé équipée d'au moins une source de lumière à semi-conducteur, notamment une diode électroluminescente, sur un support, notamment un boîtier d'excitateur, le procédé comprenant au moins les étapes suivantes :
- monter un dissipateur de chaleur sur le support de sorte qu'au moins une tige de fixation électriquement conductrice saillant du support, et qui est reliée à une alimentation électrique, traverse le dissipateur de chaleur,
- placer la plaquette de circuit imprimé sur le dissipateur de chaleur de sorte que la au moins une tige de fixation traversant le dissipateur de chaleur pénètrent au moins partiellement dans un évidement associé, notamment un trou de serrure, de la plaquette de circuit imprimé,
- fixer la au moins une tige de fixation dans l'évidement associé, de sorte qu'au moins une tige de fixation soit connectée électriquement à une source de lumière à semi-conducteur.

26. Procédé selon la revendication 25,
- le ou les évidements se présentant sous forme de trou de serrure,
- la fixation de la au moins une tige de fixation dans le trou de serrure associé s'effectuant par un mouvement de rotation entre le support et la plaquette de circuit imprimé, et
- une étape supplémentaire ayant lieu, consistant à fixer une position de rotation relative entre le support et la plaquette de circuit imprimé au moyen d'un élément de fixation.
